(19) **Europäisches Patentamt / European Patent Office / Office européen des brevets**

(11) **EP 4 367 796 B1**

(12) **FASCICULE DE BREVET EUROPEEN**

(45) Date de publication et mention de la délivrance du brevet:
**19.06.2024 Bulletin 2024/25**

(21) Numéro de dépôt: **23713377.2**

(22) Date de dépôt: **23.03.2023**

(51) Classification Internationale des Brevets (IPC):
**H03M 13/11** *(2006.01)*

(52) Classification Coopérative des Brevets (CPC):
**H03M 13/112; H03M 13/114; H03M 13/116; H03M 13/658;** H03M 13/1122

(86) Numéro de dépôt international:
**PCT/EP2023/057490**

(87) Numéro de publication internationale:
**WO 2023/217447 (16.11.2023 Gazette 2023/46)**

(54) **MISE A L'ECHELLE ADAPTATIVE DES MESSAGES DE CONTRÔLE DE PARITÉ POUR LE DECODAGE LDPC**

ADAPTIVE SKALIERUNG VON PRÜF- ZU BIT-KNOTEN NACHRICHTEN FÜR DIE LDPC-DEKODIERUNG

ADAPTIVE SCALING OF CHECK-TO-BIT NODE MESSAGES FOR LDPC DECODING

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **12.05.2022 FR 2204541**

(43) Date de publication de la demande:
**15.05.2024 Bulletin 2024/20**

(73) Titulaire: **Airbus Defence and Space SAS**
**31402 Toulouse Cedex 4 (FR)**

(72) Inventeurs:
- **BARTHE, Lyonel**
  **31402 TOULOUSE Cedex 04 (FR)**
- **GADAT, Benjamin**
  **31402 TOULOUSE Cedex 04 (FR)**

(74) Mandataire: **Ipside**
**6, Impasse Michel Labrousse**
**31100 Toulouse (FR)**

(56) Documents cités:
**EP-A1- 2 381 581     US-A1- 2017 026 055**
**US-B1- 9 059 742**

EP 4 367 796 B1

**Description**

**Domaine de l'invention**

La présente invention appartient au domaine des codes de contrôle de parité à faible densité (LDPC, pour « Low Density Parity Check »). Notamment, l'invention concerne une stratégie de quantification à la volée des données utilisées dans le processus de décodage.

**Etat de la technique**

Les codes LDPC sont actuellement utilisés dans plusieurs technologies de communication, notamment pour les normes IEEE 802.16 (WiMAX), IEE 802.11n (Wi-Fi), le standard 5G de l'organisme 3GPP (« 3rd Génération Partnership Project »), le standard DVB-S2 (« Digitial Video Broadcasting, 2nd Génération »), ou le standard de communications spatiales CCSDS C2 (« Consultative Committee for Space Data Systems, C2 »).

Un code LDPC binaire est un code correcteur d'erreurs linéaire défini par une matrice de parité binaire (les éléments de la matrice sont des '0' et des '1'). La matrice de parité est de faible densité, c'est-à-dire que le nombre d'éléments non nuls de la matrice est relativement faible par rapport à la taille M x N de la matrice.

Un code LDPC peut être représenté sous la forme d'un graphe bipartite (graphe de Tanner) présentant des connexions entre N noeuds de variable et M noeuds de contrôle de parité. Chaque élément non nul de la matrice de parité correspond à une connexion entre un noeud de variable et un noeud de contrôle de parité. Chaque ligne de la matrice de parité correspond à une équation de parité associée à un noeud de contrôle de parité. Chaque colonne de la matrice de parité correspond à une variable associée à un noeud de variable. Un mot de code à décoder correspond à un ensemble de valeurs prises respectivement par les variables associées aux différents noeuds de variable (ensemble des valeurs estimées des bits du mot de code).

Pour réduire la complexité d'implémentation matérielle d'un décodeur LDPC, il est connu d'utiliser des structures particulières de la matrice de parité. En particulier, les codes LDPC quasi-cycliques (QC-LDPC pour « Quasi-Cyclic Low Density Parity Check ») sont définis par des matrices de parité composée de sous-matrices de taille Z x Z. Le terme Z est généralement appelé « facteur d'expansion ». Les sous-matrices de taille Z x Z sont généralement appelées « matrices circulantes ». Une matrice de parité d'un code QC-LDPC est par exemple obtenue à partir d'une matrice de base de taille R x C en remplaçant chaque élément de la matrice de base par une matrice de taille Z x Z correspondant soit à une matrice nulle, soit à un décalage de la matrice identité. La matrice de parité comporte alors R x Z lignes (M = R x Z) et C x Z colonnes (N = C x Z).

Une caractéristique intéressante d'un code QC-LDPC est que sa matrice de parité est organisée en couches horizontales ou verticales. Par exemple, une couche horizontale de la matrice de parité correspond à un ensemble de L lignes consécutives de la matrice de parité provenant d'une ligne de la matrice de base (L ≤ Z). Cette structure en couche permet de paralléliser les calculs des messages de contrôle de parité au sein d'une couche car les équations de parité d'une couche ne font pas intervenir une variable du mot de code plus d'une fois. En effet, une couche présente un seul élément non nul dans la matrice de parité pour une variable donnée, ou autrement dit, les noeuds de variable connectés à un noeud de contrôle de parité d'une couche ne sont pas connectés à un autre noeud de contrôle de parité de ladite couche.

Le décodage d'un mot de code LDPC est basé sur un échange itératif d'informations sur la vraisemblance des valeurs prises par les bits du mot de code. Le processus itératif de décodage est basé sur un algorithme de propagation de croyance en échangeant des messages entre les noeuds de variable et les noeuds de contrôle de parité, et en appliquant les équations de parité. A chaque itération, des messages de variable sont calculés à partir de messages de contrôle de parité calculés lors de l'itération précédente ; les messages de contrôle de parité sont calculés pour l'itération en cours ; et des variables correspondant à une estimation du mot de code sont mises à jour à partir des messages de contrôle de parité.

Le processus itératif du décodage d'un mot de code LDPC peut notamment être basé sur l'algorithme BP (« Belief Propagation », en français « propagation des croyances ») aussi connu sous le terme SPA (« Sum-Product Algorithm », en français « algorithme Somme-Produit »). L'algorithme BP-SPA offre de bonnes performances de décodage au prix d'une complexité calculatoire élevée. Cette complexité calculatoire est liée à l'utilisation de fonctions à base de tangentes hyperboliques ou de logarithmes et d'exponentielles pour le calcul des messages de contrôle de parité.

Des variantes de l'algorithme BP-SPA ont donc été proposées pour diminuer la complexité calculatoire du décodage.

Par exemple, les algorithmes A-min* et λ-min sont proches de la formulation de l'algorithme BP-SPA, mais ils en réduisent la complexité calculatoire. Notamment, pour l'algorithme λ-min, seuls les messages de variable avec les plus faibles amplitudes sont pris en considération pour le calcul d'un message de contrôle de parité (plus l'amplitude d'un message de variable est faible, et plus il aura d'impact sur les valeurs des messages de contrôle de parité).

Selon un autre exemple, l'algorithme Min-Sum remplace les calculs de tangentes hyperboliques par des calculs de minimums pour approximer les messages de contrôle de parité. Cette approximation réduit significativement la complexité calculatoire. Cependant, elle surévalue les amplitudes des messages de contrôle de parité, ce qui conduit à une diminution des performances de correction d'erreurs. Des variantes de l'algorithme Min-Sum ont donc été introduites pour compenser cette surévaluation. C'est notamment le cas des algorithmes « Offset Min-Sum » (OMS) et « Normalized Min-Sum » (NMS). L'algorithme OMS introduit une valeur de correction (« offset » en anglais) à retrancher de la valeur calculée pour l'amplitude d'un message de contrôle de parité. L'algorithme NMS introduit quant à lui un facteur de normalisation à appliquer à la valeur calculée pour l'amplitude d'un message de contrôle de parité.

Ces différents algorithmes offrent des compromis différents en termes de complexité calculatoire et de pouvoir de correction. Le choix d'un algorithme particulier est très fortement lié au contexte dans lequel le décodage LDPC est appliqué.

Pour réduire la latence et augmenter le débit moyen du décodage, il est important de limiter le nombre d'itérations nécessaires pour corriger les erreurs. Cela permet également de limiter la consommation d'énergie du décodeur. Ainsi, une caractéristique importante d'un décodeur LDPC réside dans le critère utilisé pour arrêter le processus de décodage, c'est-à-dire le critère utilisé pour considérer que la convergence vers le mot de code correct a été atteinte.

Un critère d'arrêt peut être déterminé à partir d'un calcul de contrôle de parité sur l'ensemble des valeurs estimées des bits du mot de code à la fin d'une itération (le syndrome est alors un vecteur de taille M défini par les M équations de parité définies par la matrice de parité). Cela conduit à des taux d'erreurs relativement faibles. Toutefois, cela entraîne une latence supplémentaire car la détermination du critère d'arrêt nécessite d'interrompre le processus de décodage à chaque itération. De plus, cette solution n'est pas bien adaptée à une architecture en couches lorsque la taille N d'un mot de code est grande.

Lorsque le processus de décodage suit une architecture en couches, par exemple avec l'utilisation d'un code QC-LDPC, il est envisageable de calculer à la volée (c'est-à-dire sans interrompre le processus de décodage) un syndrome partiel pour chaque couche. Un syndrome partiel est un vecteur de taille L défini par les L équations de parité de la couche considérée (L étant la taille de la couche, c'est-à-dire le nombre de lignes consécutives de la matrice de parité correspondant à une couche dans le cas d'une structure par couches horizontales).

Il est par exemple envisageable de considérer que le critère d'arrêt est satisfait lorsque, à la fin d'une itération correspondant au traitement successif des différentes couches, tous les syndromes partiels calculés respectivement pour les différentes couches sont nuls. Il n'y a toutefois aucune garantie que les syndromes partiels soient satisfaits par un même mot de code car les estimations des valeurs des bits du mot de code sont mises à jour après le traitement de chaque couche. Cela peut entraîner une augmentation significative des fausses détections.

L'article de A. Hera et al. intitulé « Analysis and Implementation of On-the-Fly Stopping Criteria for Layered QC LDPC Decoders » et publié aux pages 287 à 291 du compte rendu de la 22ème conférence internationale « Mixed design of integrated circuits and systems » qui s'est tenue du 25 au 27 juin 2015 à Torun en Pologne, propose un critère d'arrêt qui prend en compte plusieurs itérations successives. Plus particulièrement, le critère d'arrêt est considéré comme satisfait lorsque les syndromes partiels des différentes couches sont tous nuls pour un nombre prédéterminé d'itérations successives. En augmentant le nombre d'itérations successives à considérer, il est possible de réduire les taux d'erreurs en contrepartie d'une latence plus importante et d'un débit moyen plus faible.

Pour atteindre des débits élevés, et pour limiter la complexité matérielle du décodeur, il est préférable d'utiliser une représentation des données (messages de contrôle de parité, messages de variable, variables correspondant à une estimation du mot de code) en virgule fixe. La représentation en virgule fixe peut toutefois affecter les performances du décodage en termes de taux d'erreurs. En particulier, la saturation des données utilisées dans le processus de décodage (lorsque ces données atteignent la valeur maximale permise par la représentation en virgule fixe) est à l'origine de plancher de taux d'erreurs (on parle alors de « plancher de quantification »). Le format de quantification des données doit donc être choisi avec soin dans le but d'abaisser le plancher de quantification tout en limitant la complexité d'implémentation matérielle (quand le format de quantification est grand il y a moins de saturation et le plancher de quantification est plus bas, mais la complexité d'implémentation matérielle est plus grande).

La thèse de V. Pignoly intitulée « Etude de codes LDPC pour applications spatiales optiques et conception des décodeurs associés », soumise le 26 mars 2021, présente dans les sections 1.3 et 2.1 à 2.3 le concept LDPC, le cas particulier des codes QC-LDPC, le principe de décodage en ordonnancement par couches, les différents algorithmes de décodage et la notion de quantification des données.

La thèse de T.T Nguyen Ly intitulée « Efficient Hardware Implementations of LDPC Decoders through Eploiting Impreciseness in Message-Passing Decoding Algorithms » (ci-après référencée par « Ref1 ») décrit aussi le principe de décodage LDPC pour un ordonnancement par inondation (voir sections 2.3.1 et 2.3.3) et pour un ordonnancement par couche (voir section 2.5.2).

Les communications spatiales imposent des contraintes fortes sur le codage de canal, notamment en termes de pouvoir de correction, en raison des nombreuses sources de bruit qui dégradent la qualité des signaux transmis et du coût élevé d'une éventuelle retransmission. D'autre part, les débits à atteindre sont de plus en plus élevés (les débits visés peuvent dépasser 1 Gbit/s (gigabits par seconde), voire 10 Gbit/s. En outre, la consommation énergétique et la complexité des composants électroniques embarqués dans un satellite sont généralement limitées.

Les solutions connues en termes de critère d'arrêt, d'algorithme de décodage ou de stratégie de quantification des données ne permettent pas toujours d'obtenir un compromis idéal entre performance de décodage, débit des données, complexité de l'implémentation et consommation énergétique.

La demande de brevet US2017/026055A1 et le brevet US9059742B1 décrivent chacun une stratégie de quantification des messages de contrôle ou des variables d'estimation (LLRs) lorsqu'un critère particulier de saturation est vérifié.

## Exposé de l'invention

La présente invention a pour objectif de remédier à tout ou partie des inconvénients de l'art antérieur, notamment ceux exposés ci-avant.

A cet effet, et selon un premier aspect, il est proposé par la présente invention, un procédé (100) pour décoder un mot de code avec un décodeur (10) de code de contrôle de parité de faible densité, dit code LDPC. Le code LDPC est défini par une matrice de parité (H) binaire de taille M x N, M et N étant des entiers positifs. La matrice de parité (H) correspond à une représentation d'un graphe bipartite (G) comprenant des connexions entre M noeuds de contrôle de parité ($CN_m$) et N noeuds de variable ($VN_n$). Chaque ligne de la matrice de parité (H) correspond à une équation de parité associée à un noeud de contrôle de parité ($CN_m$). Chaque colonne de la matrice de parité (H) correspond à une variable associée à un noeud de variable ($VN_n$). Chaque élément non nul de la matrice de parité (H) correspond à une connexion entre un noeud de contrôle de parité ($CN_m$) et un noeud de variable ($VN_n$). Le mot de code à décoder correspond à un ensemble de valeurs prises respectivement par lesdites variables. Le procédé (100) comprend l'exécution d'une ou plusieurs itérations jusqu'à ce qu'un critère d'arrêt soit satisfait. Chaque itération comprend :

- un calcul (111) de messages de variable ($\alpha_{n,m}$), pour les différents noeuds de variable ($VN_n$), à partir de messages de contrôle de parité ($\beta_{m,n}$),
- un calcul (112) de messages de contrôle de parité ($\beta_{m,n}$), pour les différents noeuds de contrôle de parité ($CN_m$), à partir des messages de variable ($\alpha_{n,m}$),
- lorsque la valeur calculée d'un message de contrôle de parité ($\beta_{m,n}$) ou d'une variable d'estimation a posteriori ($\gamma_n$) dépasse une valeur de saturation prédéterminée, une saturation de ladite valeur calculée à ladite valeur de saturation,
- un calcul (113) de variables d'estimation a posteriori ($\gamma_n$) à partir des messages de contrôle de parité ($\beta_{m,n}$).

A la fin d'une itération, lorsqu'un critère de saturation est vérifié, le procédé (100) comprend au moins une première mise à l'échelle (152) des messages de contrôle de parité ($\beta_{m,n}$) et des variables d'estimation a posteriori ($\gamma_n$). Une mise à l'échelle correspond à attribuer à une valeur l'entier de même signe dont la valeur absolue est l'entier le plus proche supérieur à la valeur absolue de la valeur divisée par deux. Le critère de saturation est vérifié lorsqu'une ou plusieurs des conditions suivantes est satisfaite :

- un nombre de saturations des messages de contrôle de parité est supérieur ou égal à un premier seuil de saturation,
- un nombre de saturations des variables d'estimation a posteriori est supérieur ou égal à un deuxième seuil de saturation,
- une somme du nombre de saturations des messages de contrôle de parité et du nombre de saturations des variables d'estimation a posteriori est supérieure ou égale à un troisième seuil de saturation.

Cette méthode particulière de mise à l'échelle des données à la volée permet d'abaisser le plancher de taux d'erreurs pour une quantification donnée. Elle peut également permettre d'obtenir des performances en termes de plancher de taux d'erreurs comparables à celle d'une quantification supérieure. Cela permet un gain significatif sur l'empreinte mémoire du décodeur au prix d'un surcoût d'implémentation relativement faible.

Dans des modes particuliers de mise en oeuvre, l'invention peut comporter en outre l'une ou plusieurs des caractéristiques suivantes, prises isolément ou selon toutes les combinaisons techniquement possibles.

Dans des modes particuliers de mise en oeuvre, suite à la première mise à l'échelle des messages de contrôle de parité ($\beta_{m,n}$) et des variables d'estimation a posteriori ($\gamma_n$), le procédé comprend au moins une deuxième mise à l'échelle (152) des messages de contrôle de parité ($\beta_{m,n}$) et des variables d'estimation a posteriori ($\gamma_n$) après un nombre prédéterminé d'itérations successives.

Dans des modes particuliers de mise en oeuvre, le décodeur (10) supporte différents taux de codage et le nombre prédéterminé d'itérations successives est prédéterminé en fonction du taux de codage utilisé.

Dans des modes particuliers de mise en oeuvre, le décodeur (10) supporte différents taux de codage et le seuil de saturation est prédéterminé en fonction du taux de codage utilisé.

Dans des modes particuliers de mise en oeuvre, la matrice de parité (H) présente une structure en couches horizontales. Chaque couche correspond à une ou plusieurs lignes consécutives de la matrice de parité (H). Chaque couche présente un seul élément non nul pour une variable donnée.

Dans des modes particuliers de mise en oeuvre, le code LDPC est un code quasi-cyclique. La matrice de parité (H) est obtenue en étendant une matrice de base (B) de taille R x C par un facteur d'expansion Z, Z étant un entier positif. Chaque élément de la matrice de base (B) est remplacé par une matrice de taille Z x Z correspondant soit à une matrice nulle, soit à un décalage d'une matrice identité. La matrice de parité (H) comporte alors R x Z lignes et C x Z colonnes.

Dans des modes particuliers de mise en oeuvre, chaque couche correspond aux Z lignes de la matrice de parité (H) correspondant à une ligne de la matrice de base (B).

Dans des modes particuliers de mise en oeuvre, le code LDPC est un code irrégulier de type à « accumulation répétition accumulation », dit code LDPC ARA, ou de type à « répétition irrégulière accumulation », dit code LDPC IRA, ou de type Raptor basé sur un protographe, dit code LDPC PBRL.

Dans des modes particuliers de mise en oeuvre, N est supérieur ou égal à 1000.

Dans des modes particuliers de mise en oeuvre, le décodeur (10) est configuré pour décoder un mot code avec un débit supérieur ou égal à 100 Mbit/s.

Selon un deuxième aspect, la présente invention concerne un décodeur (10) de code de contrôle de parité de faible densité, dit code LDPC. Le code LDPC est défini par une matrice de parité (H) binaire de taille M x N, M et N étant des entiers positifs. La matrice de parité (H) correspond à une représentation d'un graphe bipartite (G) comprenant des connexions entre M noeuds de contrôle de parité ($CN_m$) et N noeuds de variable ($VN_n$). Chaque ligne de la matrice de parité (H) correspond à une équation de parité associée à un noeud de contrôle de parité ($CN_m$). Chaque colonne de la matrice de parité (H) correspond à une variable associée à un noeud de variable ($VN_n$). Chaque élément non nul de la matrice de parité (H) correspond à une connexion entre un noeud de contrôle de parité ($CN_m$) et un noeud de variable ($VN_n$). Un mot de code à décoder correspond à un ensemble de valeurs prises respectivement par lesdites variables. Le décodeur (10) comporte une unité de traitement (16) configurée pour exécuter une ou plusieurs itérations jusqu'à ce qu'un critère d'arrêt soit satisfait et, à chaque itération, pour :

- calculer des messages de variable ($\alpha_{n,m}$), pour les différents noeuds de variables, à partir de messages de contrôle de parité ($\beta_{m,n}$),
- calculer des messages de contrôle de parité ($\beta_{m,n}$),pour les différents noeuds de contrôle de parité, à partir des messages de variable ($\alpha_{n,m}$),
- lorsque la valeur calculée d'un message de contrôle de parité ($\beta_{m,n}$) ou d'une variable d'estimation a posteriori ($\gamma_n$) dépasse une valeur de saturation prédéterminée, ladite valeur calculée est saturée à ladite valeur de saturation,
- calculer des variables d'estimation a posteriori ($\gamma_n$) à partir des messages de contrôle de parité ($\beta_{m,n}$).

A la fin d'une itération, lorsqu'un critère de saturation est vérifié, l'unité de traitement (16) est configurée pour effectuer une première mise à l'échelle des messages de contrôle de parité ($\beta_{m,n}$) et des variables d'estimation a posteriori ($\gamma_n$). Une mise à l'échelle correspond à attribuer à une valeur l'entier de même signe dont la valeur absolue est l'entier le plus proche supérieur à la valeur absolue de la valeur divisée par deux. Le critère de saturation est vérifié lorsqu'une ou plusieurs des conditions suivantes est satisfaite :

- un nombre de saturations des messages de contrôle de parité est supérieur ou égal à un premier seuil de saturation,
- un nombre de saturations des variables d'estimation a posteriori est supérieur ou égal à un deuxième seuil de saturation,
- une somme du nombre de saturations des messages de contrôle de parité et du nombre de saturations des variables d'estimation a posteriori est supérieure ou égale à un troisième seuil de saturation.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, suite à la première mise à l'échelle des messages de contrôle de parité ($\beta_{m,n}$) et des variables d'estimation a posteriori ($\gamma_n$), l'unité de traitement est configurée pour effectuer au moins une deuxième mise à l'échelle des messages de contrôle de parité ($\beta_{m,n}$) et des variables d'estimation a posteriori ($\gamma_n$) après un nombre prédéterminé d'itérations successives.

Dans des modes particuliers de réalisation, le décodeur (10) supporte différents taux de codage et le nombre prédéterminé d'itérations successives est prédéterminé en fonction du taux de codage utilisé.

Dans des modes particuliers de réalisation, le décodeur (10) supporte différents taux de codage et le seuil de saturation est prédéterminé en fonction du taux de codage utilisé.

Selon un deuxième aspect, la présente invention concerne un satellite comportant un décodeur (10) selon l'un quelconque des modes de réalisation précédents.

**Présentation des figures**

L'invention sera mieux comprise à la lecture de la description suivante, donnée à titre d'exemple nullement limitatif, et faite en se référant aux figures 1 à 18 qui représentent :

[Fig. 1] une représentation schématique d'une matrice de parité d'un code LDPC,

[Fig. 2] une représentation schématique d'un graphe bipartite (graphe de Tanner) associé à une matrice de parité,

[Fig. 3] une illustration d'une méthode utilisée pour obtenir une matrice de parité d'un code LDPC quasi-cyclique,

[Fig. 4] une représentation schématique d'un exemple de mise en oeuvre d'un procédé pour décoder un mot de code LDPC avec un ordonnancement par couches,

[Fig. 5] une représentation schématique d'un exemple de réalisation d'un décodeur permettant de mettre en oeuvre un procédé de décodage tel que celui décrit en référence à la figure 4,

[Fig. 6] une représentation schématique d'un exemple de mise en oeuvre d'une évaluation d'un critère d'arrêt selon l'invention,

[Fig. 7] un graphique présentant différentes courbes de taux d'erreurs de trame obtenues pour un taux de codage égal à 9/10 et pour différentes valeurs de seuil d'arrêt,

[Fig. 8] un graphique présentant différentes courbes de taux d'erreurs de trame obtenues pour un taux de codage égal à ½ et pour différentes valeurs de seuil d'arrêt,

[Fig. 9] un graphique présentant différentes courbes de taux d'erreurs de trame obtenues pour un taux de codage égal à 3/10 et pour différentes valeurs de seuil d'arrêt,

[Fig. 10] une représentation schématique d'un exemple de mise en oeuvre du calcul d'un message de contrôle de parité avec la méthode dite « AOMS » (acronyme anglais pour « Adapted Offset Min-Sum »),

[Fig. 11] une représentation schématique d'un exemple d'implémentation matérielle du calcul d'un message de contrôle de parité avec la méthode AOMS,

[Fig. 12] une représentation schématique d'un autre exemple d'implémentation matérielle du calcul d'un message de contrôle de parité avec la méthode AOMS,

[Fig. 13] un graphique présentant différentes courbes de taux d'erreurs de trame obtenues avec un taux de codage égal à 1/2, avec différentes méthodes de calcul d'un message de contrôle de parité, et avec un nombre maximal d'itérations fixé à vingt-cinq ou cinquante itérations,

[Fig. 14] une représentation schématique d'un exemple de mise en oeuvre d'un procédé de décodage LDPC avec un ordonnancement par inondation,

[Fig. 15] un graphique présentant différentes courbes de taux d'erreurs de trame obtenues avec un taux de codage égal à 3/10, avec différentes méthodes de calcul d'un message, avec différents niveaux de quantification des données, et avec un nombre maximal d'itérations fixé à cinquante itérations,

[Fig. 16] un exemple de mise en oeuvre d'un procédé de décodage LDPC similaire à celui décrit en référence à la figure 4 avec en plus une mise à l'échelle des données, [Fig. 17] un graphique similaire à celui de la figure 15 avec une courbe supplémentaire correspondant à la méthode AOMS avec une quantification L6-G9-B7 et avec une mise à l'échelle des données,

[Fig. 18] un exemple de mise en oeuvre d'un procédé de décodage LDPC avec un ordonnancement par inondation et avec une mise à l'échelle des données.

Dans ces figures, des références identiques d'une figure à une autre désignent des éléments identiques ou analogues. Pour des raisons de clarté, les éléments représentés ne sont pas nécessairement à une même échelle, sauf mention contraire.

**Description détaillée d'un mode de réalisation de l'invention**

Dans la suite de la description, on se place de manière non limitative dans le cas d'un décodeur LDPC pour des communications spatiales. Le CCSDS (acronyme anglais pour « Consultative Committee for Space Data Systems », en français « comité consultatif sur les systèmes de données spatiales ») est actuellement en train de définir un standard pour des communications spatiales optiques pour lequel des codes LDPC ont été définis par la société AIRBUS DEFENCE AND SPACE et le Centre National d'Etudes Spatiales (CNES). L'invention s'applique particulièrement bien à ce standard de communication. L'invention pourrait toutefois aussi s'appliquer à d'autres types de communications, notamment des communications radio. Les débits de données visés pour les communications spatiales considérées sont relativement élevés, par exemple supérieurs à 100 Mbit/s, voire supérieurs à 1 Gbit/s, voire même supérieurs à 10 Gbit/s. Rien n'empêcherait toutefois d'appliquer l'invention à un cas où le débit de données serait inférieur à ces valeurs.

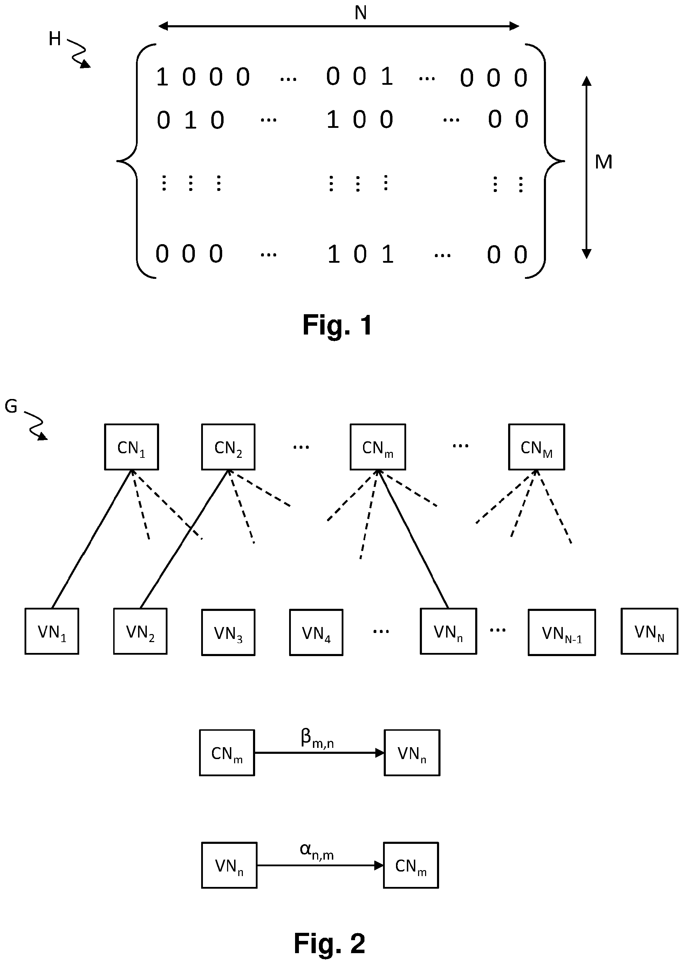

Un code LDPC est défini par une matrice de parité. La figure 1 représente schématiquement une matrice de parité H d'un code LDPC. On se place dans le cas d'un code LDPC binaire. La matrice de parité H est donc une matrice binaire, ce qui signifie que chaque élément de la matrice H est soit un '0' soit un '1'. On considère que la matrice H est de taille M x N, avec M et N des entiers positifs. La matrice comporte donc M lignes et N colonnes. La matrice de parité H est de faible densité, c'est-à-dire que le nombre d'éléments de la matrice égaux à '1' est relativement faible par rapport au nombre total M x N d'éléments de la matrice. Par exemple, le nombre d'éléments non nuls de la matrice est inférieur à 0,1% du nombre total d'éléments de la matrice.

Tel qu'illustré sur la figure 2, un code LDPC peut également être représenté sous la forme d'un graphe G bipartite (graphe de Tanner) présentant des connexions entre N noeuds de variable $VN_n$ (n variant entre 1 et N) et M noeuds de contrôle de parité $CN_m$ (m variant entre 1 et M). Chaque élément non nul de la matrice de parité H correspond à une connexion entre un noeud de variable $VN_n$ et un noeud de contrôle de parité $CN_m$. Chaque ligne de la matrice de parité H correspond à une équation de parité associée à un noeud de contrôle de parité $CN_m$. Chaque colonne de la matrice de parité H correspond à une variable associée à un noeud de variable $VN_n$. Un mot de code à décoder correspond à un ensemble de valeurs prises respectivement par les variables associées aux N noeuds de variable (c'est l'ensemble des valeurs estimées des bits du mot de code).

Un mot de code peut présenter une taille relativement importante, par exemple une taille supérieure ou égale à 1000 bits (N ≥ 1000). Dans l'exemple considéré, le mot de code a une taille de 30720 bits (N = 30720) (on se place ici après une étape de poinçonnage de certains bits d'information).

On se place dans le cas d'un décodeur LDPC qui supporte différents taux de codage. Le taux de codage correspond au rapport entre le nombre de bits utiles dans un mot de code sur le nombre total de bits d'un mot de code. Plus le taux de codage est grand, plus la complexité calculatoire est faible et plus le débit peut être élevé ; en contrepartie, le pouvoir de correction d'erreurs est plus faible (et donc le taux d'erreurs est plus important). Inversement, plus le taux de codage est petit et plus le pouvoir de correction d'erreurs est important (taux d'erreurs faible) ; en contrepartie, la complexité calculatoire est plus forte et le débit est moins élevé.

Dans l'exemple considéré, le nombre de lignes M et la densité de la matrice de parité dépendent du taux de codage. Pour un taux de codage de 9/10, M = 4608 et la densité vaut 0,0816%. Pour un taux de codage de 1/2, M = 17920 et la densité vaut 0,024%. Pour un taux de codage de 3/10, M = 23040 et la densité vaut 0,0213%.

Le décodage d'un mot de code LDPC est basé sur un échange itératif d'informations sur la vraisemblance des valeurs prises par les bits du mot de code. Le processus itératif de décodage est basé sur un algorithme de propagation de croyance qui repose sur un échange de messages entre les noeuds de variable $VN_n$ et les noeuds de contrôle de parité $CN_m$.

Tel qu'illustré sur la figure 2, un message envoyé par un noeud de contrôle de parité $CN_m$ à destination d'un noeud de variable $VN_n$ est noté $\beta_{m,n}$ (on utilise aussi parfois la notation $c2v_{m,n}$ pour traduire la notion de direction du message d'un noeud de contrôle de parité vers un noeud de variable). La valeur d'un message $\beta_{m,n}$ est calculée au niveau du noeud de parité $CN_m$ pour chacun des noeuds de variable $VN_n$ connectés au noeud de contrôle de parité $CN_m$ sur le graphe G.

Un message envoyé par un noeud de variable $VN_n$ à destination d'un noeud de contrôle de parité $CN_m$ est noté $\alpha_{n,m}$ (on utilise aussi parfois la notation $v2c_{n,m}$ pour traduire la notion de direction du message d'un noeud de variable vers un noeud de contrôle de parité). La valeur d'un message $\alpha_{n,m}$ est calculée au niveau d'un noeud de variable $VN_n$ pour chacun des noeuds de parité $CN_m$ connectés au noeud de variable $VN_n$ sur le graphe G.

C'est un processus itératif : les messages $\alpha_{n,m}$ sont calculés à partir des messages $\beta_{m,n}$ précédemment calculés, et les messages $\beta_{m,n}$ sont calculés à partir des messages $\alpha_{n,m}$ précédemment calculés. Ce processus itératif prend en entrée des variables d'estimation a priori du mot de code qui correspondent par exemple à des logarithmes de rapport de vraisemblance (LLR pour « Log-Likelihood Ratio » en anglais). Ce sont des valeurs représentatives de la probabilité que la valeur d'un bit du mot de code soit égale à '1' ou à '0' (logarithme du rapport entre la probabilité que la valeur du bit est égale à '0' et la probabilité que la valeur du bit est égale à '1').

Des variables d'estimation a posteriori $\gamma_n$ (n variant de 1 à N) des bits du mot de code sont également calculées itérativement à partir des messages $\beta_{m,n}$. Ces valeurs $\gamma_n$ sont également représentatives de la probabilité que la valeur d'un bit du mot de code soit égale à '1 ' ou à '0'. Elles permettent de prendre une décision sur la valeur de chacun des bits du mot de code. Un syndrome peut alors être calculé à partir des valeurs estimées des bits du mot de code et des équations de parité définie par la matrice de parité H. Si on note c = ($c_1$, $c_2$, ..., $c_N$) l'ensemble des valeurs estimées des bits du mot de code, alors le syndrome s est défini par l'équation matricielle s = H * $c^T$. Un syndrome nul signifie que les valeurs estimées des bits du mot de code satisfont les équations de parité.

L'algorithme 1 défini à la section 2.3.1 du document Ref1 décrit un exemple de processus itératif de décodage LDPC avec l'algorithme BP-SPA. L'algorithme 2 défini à la section 2.3.3 du document Ref1 décrit un exemple de processus itératif de décodage LDPC avec l'algorithme Min-Sum. Ces algorithmes conventionnels sont connus de l'homme du métier.

Ces deux algorithmes sont présentés dans le cas d'un ordonnancement par inondation. Les messages $\alpha_{n,m}$

et les valeurs $\gamma_n$ sont initialisés avec les variables d'estimation a priori. Ensuite, à chaque itération, les messages $\beta_{m,n}$ sont calculés à partir des messages $\alpha_{n,m}$ ; les messages $\alpha_{n,m}$ sont calculés à partir des messages $\beta_{m,n}$ et des variables d'estimation a priori ; les variables d'estimation a posteriori $\gamma_n$ sont calculées à partir des messages $\beta_{m,n}$ et des variables d'estimation a priori. Un syndrome peut ensuite être calculé à partir des variables d'estimation a posteriori $\gamma_n$.

Pour réduire la complexité d'implémentation matérielle du décodeur LDPC, il est possible d'utiliser des structures particulières de la matrice de parité H qui confèrent à la matrice une organisation en couches horizontales ou verticales. Par exemple, une couche horizontale de la matrice de parité H peut être définie comme un ensemble de lignes consécutives définies de telle sorte que, pour une variable donnée (c'est-à-dire pour une colonne donnée de la matrice de parité H), la couche ne présente qu'un seul élément non nul.

Cette structure en couche permet de paralléliser les calculs des messages de contrôle de parité au sein d'une couche car les équations de parité d'une couche ne font pas intervenir plus d'une fois une variable du mot de code. En effet, si une couche ne présente qu'un seul élément non nul pour une variable donnée, cela signifie que les noeuds de variable $VN_n$ connectés à un noeud de contrôle de parité $CN_m$ d'une couche ne sont pas connectés à un autre noeud de contrôle de parité de ladite couche.

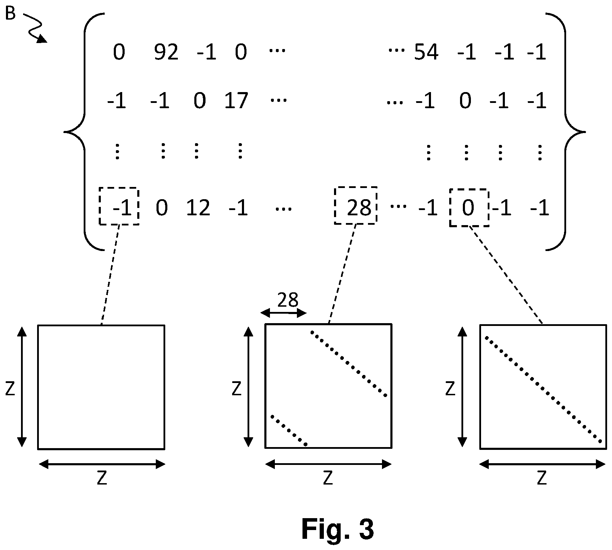

Il existe différentes façons d'obtenir une matrice de parité H présentant une structure en couches. Notamment, et tel qu'illustré sur la figure 3, il est possible d'obtenir une matrice de parité H à partir d'une matrice de base B de taille R x C en remplaçant chaque élément de la matrice de base B par une matrice de taille Z x Z correspondant soit à une matrice nulle, soit à la matrice identité, soit à un décalage de la matrice identité. La matrice de parité comporte alors R x Z lignes (M = R x Z) et C x Z colonnes (N = C x Z). Le terme Z est un généralement appelé « facteur d'expansion ». Les sous-matrices de taille Z x Z sont généralement appelées « matrices circulantes ». Les termes R, C et Z sont des entiers positifs. Un code LDPC défini par une telle matrice de parité H est appelé code LDPC « quasi-cyclique » (QC-LDPC).

Par exemple, et tel qu'illustré sur la figure 3, chaque élément de la matrice de base B est un entier ayant pour valeur '-1', '0', ou une valeur inférieure à Z. Un élément de la matrice de base B ayant pour valeur '-1' est remplacé par la matrice nulle ; un élément de la matrice de base B ayant pour valeur '0' est remplacé par la matrice identité ; un élément de la matrice de base B ayant une valeur d comprise entre 1 et (Z-1) est remplacé un décalage de valeur d de la matrice identité.

Une couche horizontale de la matrice de parité H peut alors être définie comme un ensemble de L lignes consécutives de la matrice de parité H provenant d'une ligne de la matrice de base B, avec $L \leq Z$.

Dans l'exemple considéré, et de manière nullement limitative, le facteur d'expansion Z est égal à 128.

Un code QC-LDPC peut également être obtenu par une répétition d'un protographe (un protographe est un graphe bipartite) et des permutations, en suivant des règles prédéterminées, des liens de connexion existant entre ses noeuds (les permutations sont définies par des matrices circulantes).

De nombreux types de codes LDPC correspondent à des codes quasi-cycliques et/ou à des juxtapositions et/ou à des combinaisons de code quasi-cycliques. Il peut s'agir, par exemple, d'un code irrégulier de type à « accumulation répétition accumulation » (code LDPC ARA), ou de type à « répétition irrégulière accumulation » (code LDPC IRA), ou de type Raptor basé sur un protographe (code LDPC PBRL).

Dans une architecture par couches horizontales, les calculs sont principalement centrés sur les noeuds de contrôle de parité $CN_m$. Le nombre L correspond au nombre d'unité fonctionnelles utilisées pour exécuter en parallèle les calculs effectués au niveau des noeuds de contrôle de parité. Lorsque L = Z, le niveau de parallélisation est maximal.

Un ordonnancement basé sur une structure en couches horizontales permet de doubler la vitesse de convergence du processus de décodage (il faut deux fois moins d'itérations avec un ordonnancement par couches horizontales pour atteindre des performances équivalentes à celles obtenues avec un ordonnancement par inondation). En outre, l'empreinte mémoire d'un décodeur basé sur un ordonnancement par couches horizontales est plus faible que celle d'un décodeur basé sur un ordonnancement par inondation car il n'est pas nécessaire de stocker les messages $\alpha_{n,m}$. L'utilisation d'un code QC-LDPC permet en outre de simplifier le réseau de permutation du décodeur en exploitant les propriétés linéaires de l'opération de rotation.

L'algorithme 7 défini à la section 2.5.2 du document Ref1 décrit un exemple de processus itératif de décodage LDPC avec l'algorithme Min-Sum dans le cas d'un ordonnancement par couches horizontales. Les variables d'estimation a posteriori $\gamma_n$ sont initialisées avec les variables d'estimation a priori (LLRs). Les messages $\beta_{m,n}$ sont initialisés à zéro. Ensuite, à chaque itération, les différentes couches sont traitées successivement. Pour chaque couche : les messages $\alpha_{n,m}$ sont calculés à partir des messages $\beta_{m,n}$ et des variables d'estimation a posteriori $\gamma_n$ ; les messages $\beta_{m,n}$ sont calculés à partir des messages $\alpha_{n,m}$ ; les variables d'estimation a posteriori $\gamma_n$ sont calculées à partir des messages $\beta_{m,n}$ ; un syndrome partiel peut alors être calculé à partir des variables d'estimation a posteriori $\gamma_n$.

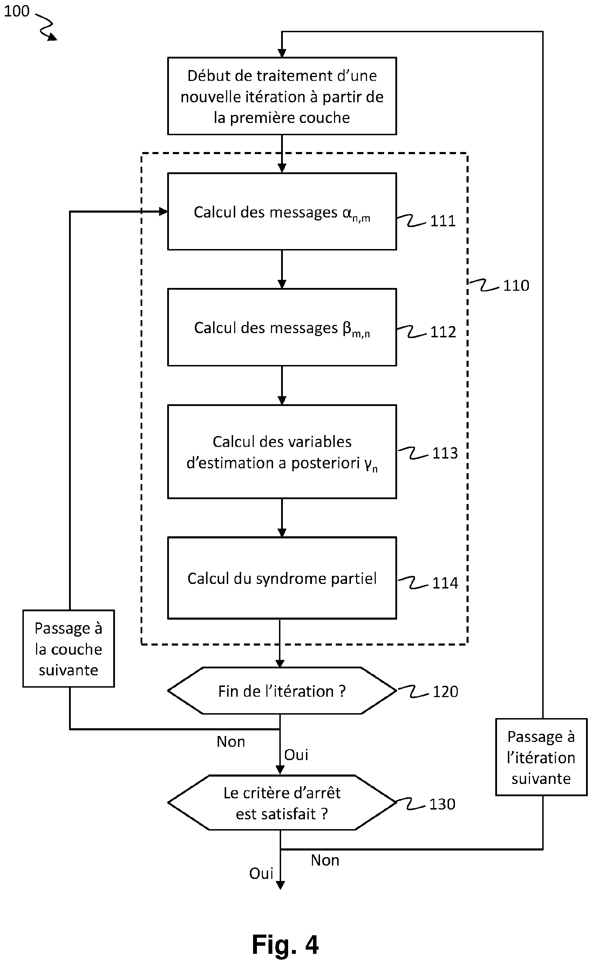

La figure 4 illustre schématiquement un exemple de mise en oeuvre d'un procédé 100 pour décoder un mot de code LDPC avec un décodeur présentant une architecture en couches horizontales.

Tel qu'illustré sur la figure 4, le procédé 100 comprend l'exécution d'une ou plusieurs itérations jusqu'à ce qu'un critère d'arrêt soit satisfait. Chaque itération comprend le traitement successif des couches de la matrice de parité H.

Le traitement 110 d'une couche comprend :

- un calcul 111 de messages de variable $\alpha_{n,m}$, pour les noeuds de variables $VN_n$ impliqués dans ladite couche,
- un calcul 112 de messages de contrôle de parité $\beta_{m,n}$, pour les noeuds de contrôle de parité $CN_m$ impliqués dans ladite couche,
- un calcul 113 des variables d'estimation a posteriori $\gamma_n$,
- un calcul 114 d'un syndrome partiel pour ladite couche.

Le calcul 111 d'un message de variable $\alpha_{n,m}$ est effectué pour chaque noeud de variable $VN_n$ impliqué dans la couche en cours de traitement et pour chacun des noeuds de contrôle de parité $CN_m$ connectés audit noeud de variable $VN_n$. Les messages $\alpha_{n,m}$ sont calculés à partir des valeurs courantes des variables d'estimation a posteriori $\gamma_n$ et à partir des valeurs courantes des messages de contrôle de parité $\beta_{m,n}$. Ces valeurs courantes correspondent soit aux valeurs d'initialisation (pour la première itération) soit aux valeurs calculées lors de l'itération précédente. Par exemple, un message $\alpha_{n,m}$ est calculé tel que $\alpha_{n,m} = \gamma_n - \beta_{m,n}$.

Le calcul 112 d'un message de contrôle de parité $\beta_{m,n}$ est effectué pour chaque noeud de contrôle de parité $CN_m$ impliqué dans la couche en cours de traitement et pour chacun des noeuds de variable $VN_n$ connectés audit noeud de contrôle de parité $CN_m$. Les messages $\beta_{m,n}$ sont calculés à partir des valeurs courantes des messages de variable $\alpha_{n,m}$. Par exemple, un message $\beta_{m,n}$ est calculé en considérant l'ensemble des messages $\alpha_{n',m}$ associés au noeud de contrôle de parité $CN_m$ en excluant le message $\alpha_{n,m}$ associé au noeud de variable $VN_n$ ;la valeur absolue d'un message $\beta_{m,n}$ est égale à la plus petite valeur absolue des messages $\alpha_{n',m}$ considérés ; le signe d'un message $\beta_{m,n}$ est égal au produit des signes des messages $\alpha_{n',m}$ considérés.

Le calcul 113 d'une valeur de la variable d'estimation a posteriori $\gamma_n$ est effectué pour chaque bit du mot de code. Par exemple, les $\gamma_n$ sont calculés à partir des valeurs courantes des messages de contrôle de parité $\beta_{m,n}$ et des valeurs courantes des messages de variable $\alpha_{n,m}$ de telle sorte que $\gamma_n = \alpha_{n,m} + \beta_{m,n}$.

Le calcul 114 d'un syndrome partiel pour la couche en cours de traitement est effectué en appliquant les équations de parité de ladite couche aux variables d'estimation a posteriori $\gamma_n$. Le syndrome partiel est alors un vecteur de taille L.

Le procédé 100 comporte, à la fin du traitement de chaque couche, une vérification 120 si l'itération est terminée ou non. L'itération est terminée lorsque toutes les couches ont été traitées.

A la fin d'une itération, le procédé 100 comporte une évaluation 130 d'un critère d'arrêt. Il est par exemple envisageable de considérer que le critère d'arrêt est satisfait lorsque tous les syndromes partiels calculés respectivement pour les différentes couches sont nuls.

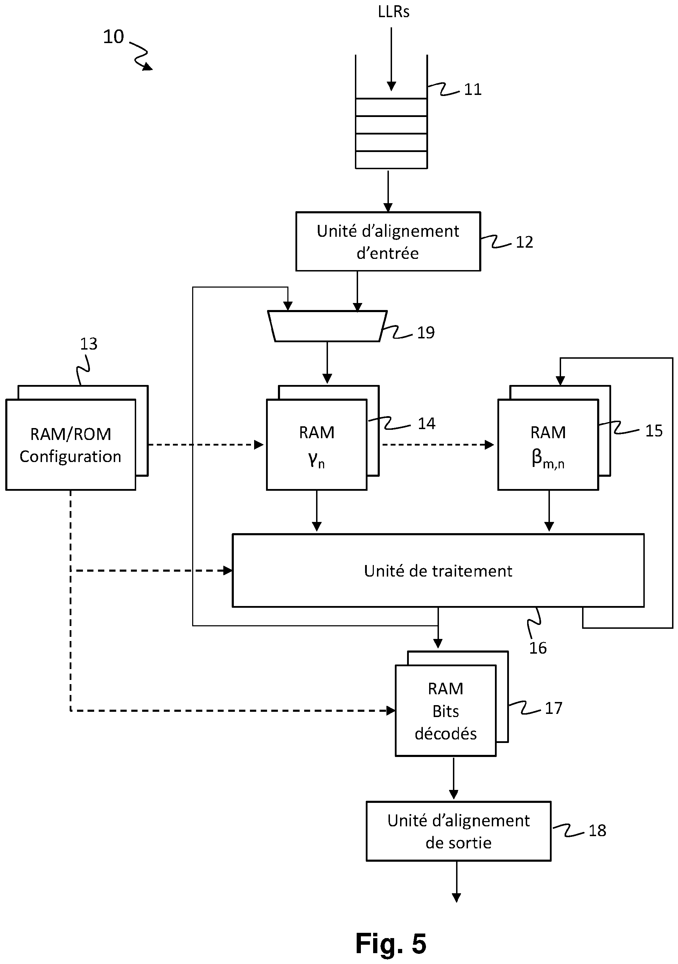

La figure 5 illustre schématiquement un exemple de réalisation d'un décodeur 10 permettant de mettre en oeuvre un procédé 100 de décodage LDPC tel que celui décrit en référence à la figure 4. Il convient toutefois de noter qu'il existe dans la littérature de nombreuses architectures possibles pour l'implémentation de décodeurs LDPC présentant une structure en couches. Dans l'exemple illustré à la figure 5, le décodeur 10 comporte :

- une mémoire tampon d'entrée 11 de type premier entré-premier sorti (« First In First Out » ou FIFO dans la littérature anglo-saxonne) pour mettre en mémoire une trame de données pendant qu'une autre trame de données est en cours de traitement,
- une unité d'alignement d'entrée 12 pour former des blocs de bits de données à décoder de la taille du facteur de parallélisation L,
- une mémoire 13 volatile (« Random Access Memory » ou RAM) ou non volatile (« Read-Only Memory » ou ROM) dans laquelle sont mémorisées des informations de configuration relative au code LDPC, comme par exemple la matrice de parité H à utiliser (qui peut être mémorisée sous toute forme adaptée),
- une mémoire 14 volatile dans laquelle sont mémorisés les valeurs courantes des variables d'estimation a posteriori $\gamma_n$,
- une mémoire 15 volatile dans laquelle sont mémorisés les valeurs courantes des messages de contrôle de parité $\beta_{m,n}$,
- une unité de traitement 16 configurée pour exécuter les itérations du processus de décodage, c'est-à-dire notamment pour mettre en oeuvre le réseau de permutation du décodeur (opérations de décalage de la matrice identité), pour effectuer les calculs des variables d'estimation a posteriori $\gamma_n$, des messages $\alpha_{n,m}$ et $\beta_{m,n}$, des syndromes partiels, et pour déterminer si le critère d'arrêt est satisfait,
- un multiplexeur 19 pour aiguiller dans la mémoire 14 les valeurs des variables d'estimation a priori (pour la première itération) ou les valeurs des variables d'estimation a posteriori $\gamma_n$ calculées par l'unité de traitement 16 (pour les itérations suivantes),
- une mémoire 17 volatile dans laquelle sont mémorisées les valeurs de décision dure (« hard decision » dans la littérature anglo-saxonne) des bits du mot de code,
- une unité d'alignement de sortie 18 pour adapter la taille des blocs de bits de données décodées à la taille attendue en sortie du décodeur 10.

Le décodeur 10 est par exemple implémenté sous la forme d'un circuit intégré spécifique de type ASIC (acronyme anglais pour « Application-Specific Integrated Circuit », ou un circuit intégré reprogrammable de type FPGA (acronyme anglais pour « Field-Programmable Gate Array »).

Le décodeur 10 est par exemple embarqué dans un dispositif récepteur d'une charge utile d'un satellite destiné à être placé en orbite autour de la Terre, ou dans un dispositif récepteur d'une station de communication au sol.

Critère d'arrêt :

Les solutions connues pour déterminer le critère d'arrêt ne permettent pas toujours d'obtenir un compromis idéal entre performance de décodage, débit des données, complexité de l'implémentation et consommation énergétique.

La solution simple consistant à vérifier à la fin d'une itération si tous les syndromes partiels calculés respectivement pour les différentes couches sont nuls conduit à des planchers de taux d'erreurs relativement élevés (il n'y a aucune garantie que les syndromes partiels soient satisfaits par un même mot de code car les variables d'estimation a posteriori $\gamma_n$ sont mises à jour après le traitement de chaque couche).

La solution consistant à vérifier si les syndromes partiels des différentes couches sont tous nuls pour un nombre prédéterminé d'itérations successives n'est pas toujours satisfaisante non plus car cela peut entraîner une latence liée à une augmentation du nombre d'itérations nécessaires pour satisfaire le critère d'arrêt.

Une solution particulière pour évaluer le critère d'arrêt est proposée ci-après. Dans cette solution, l'évaluation 130 du critère d'arrêt comprend une vérification si, pour une pluralité d'itérations successives, le nombre d'itérations pour lesquelles tous les syndromes partiels sont nuls auquel est retranché le nombre d'itérations pour lesquelles l'un au moins des syndromes partiels est non nul est supérieur ou égal à un seuil d'arrêt prédéterminé. Si c'est le cas, alors le critère d'arrêt peut être considéré comme satisfait.

Cette solution est relativement peu complexe et donc facile à implémenter. En outre, elle permet d'atteindre des planchers de taux d'erreurs plus bas par rapport à une approche classique de compteur. Cette solution permet en effet de filtrer les oscillations du compteur qui peuvent être observées pour des rapports signal sur bruit faibles (SNR pour « Signal to Noise Ratio »). Cette solution offre une meilleure robustesse pour les taux de codage faibles tout en fournissant une vitesse de convergence équivalente pour les autres cas. Cette solution permet également d'augmenter la vitesse de convergence pour les SNR faibles car il n'est plus nécessaire de surdimensionner le seuil d'arrêt pour obtenir un plancher de taux d'erreurs similaire à celui obtenu avec une approche classique de compteur.

Il convient de noter que d'autres conditions peuvent venir s'ajouter à l'évaluation 130 du critère d'arrêt, comme par exemple la condition selon laquelle un nombre minimal d'itérations a déjà été effectué.

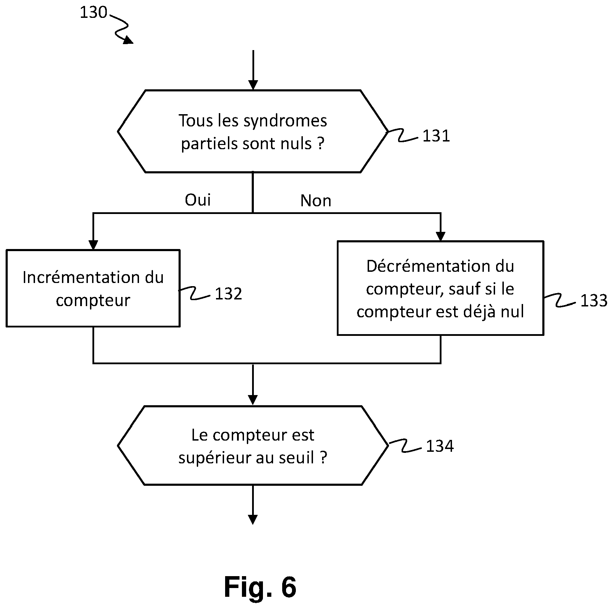

La figure 6 décrit un mode particulier de mise en oeuvre de l'évaluation 130 du critère d'arrêt basée sur cette solution. Dans ce mode particulier de mise en oeuvre, un compteur est initialisé à zéro et, à la fin de chaque itération :

- on vérifie (étape 131) si tous les syndromes partiels calculés pour les différentes couches au cours de l'itération qui vient de se terminer sont nuls,
- si l'un au moins des syndromes partiels est non nul, on décrémente (étape 133) le compteur d'une unité, sauf si le compteur est égal à zéro,
- si tous les syndromes partiels sont nuls, on incrémente (étape 132) le compteur,
- on vérifie (étape 134) si le compteur est supérieur ou égal au seuil d'arrêt (le critère d'arrêt est satisfait si c'est le cas).

Il existe bien entendu d'autres manières de mettre en oeuvre cette solution. Par exemple, il est possible d'initialiser le compteur à une valeur prédéterminée non nulle, de décrémenter le compteur lorsque tous les syndromes partiels sont nuls, et d'incrémenter le compteur si l'un au moins des syndromes partiels n'est pas nul et si le compteur est strictement inférieur à sa valeur d'initialisation. Le critère d'arrêt est alors satisfait lorsque le compteur devient égal à zéro.

Lorsque le décodeur supporte différents taux de codage, la valeur du seuil d'arrêt peut être prédéterminée en fonction du taux de codage utilisé (par exemple, plus le taux de codage est petit, et plus le seuil d'arrêt est élevé).

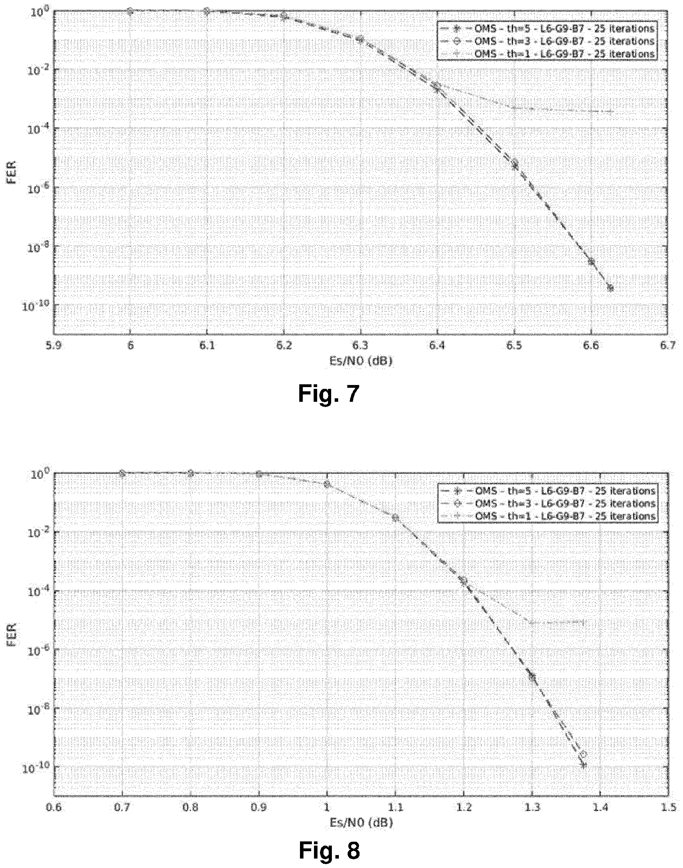

Les figures 7, 8 et 9 représentent des graphiques avec différentes courbes de taux d'erreurs de trame (FER pour « Frame Error Rate » en anglais) obtenues pour des valeurs de seuil d'arrêt égales à un (th = 1), trois (th = 3) et cinq (th = 5). Le taux d'erreur de trame (FER) est représenté en ordonnées, le rapport signal sur bruit (SNR) est représenté en abscisses ($Es/N_0$ représente un rapport entre l'énergie du signal Es et l'énergie du bruit $N_0$). Pour obtenir ces résultats, la méthode OMS est utilisée, les LLRs sont quantifiés sur six bits (« L6 »), les variables d'estimation a posteriori $\gamma_n$ sont quantifiées sur neuf bits (« G9 ») et les messages $\beta_{m,n}$ sont quantifiés sur sept bits (« B7 »). Les résultats sont fournis pour un nombre maximal d'itérations fixé à vingt-cinq itérations (au-delà le processus de décodage est interrompu, en pratique cela signifie que le SNR est trop faible pour permettre un décodage avec le code utilisé).

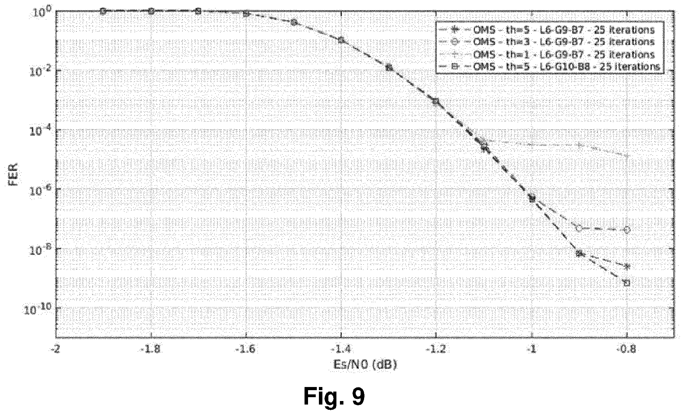

La figure 7 correspond à un taux de codage égal à 9/10, la figure 8 correspond à un taux de codage égal à 1/2 et la figure 9 correspond à un taux de codage égal à 1/3. On peut observer sur ces figures qu'un plancher de taux d'erreurs inférieur à $10^{-9}$ est obtenu pour un seuil d'arrêt égal à trois pour les taux de codage 9/10 et 1/2. En revanche, pour le taux de codage 3/10 il est nécessaire d'utiliser un seuil d'arrêt égal à cinq pour obtenir un plancher de taux d'erreurs inférieur à $10^{-8}$ (et un plancher de taux d'erreurs inférieur à $10^{-9}$ peut être obtenu pour une quantification L6-G10-B8).

Il convient de noter que l'évaluation 130 du critère d'arrêt n'est pas nécessairement effectuée à chaque itération. L'évaluation 130 du critère d'arrêt peut par exemple être effectuée de façon périodique après un certain nombre d'itérations successives.

Méthode « Adapted Offset Min-Sum » (AOMS) :

Les méthodes utilisées dans l'art antérieur pour calculer les messages de contrôle de parité $\beta_{m,n}$ ne permettent pas toujours d'obtenir un compromis idéal entre performance de décodage, débit des données et complexité de l'implémentation.

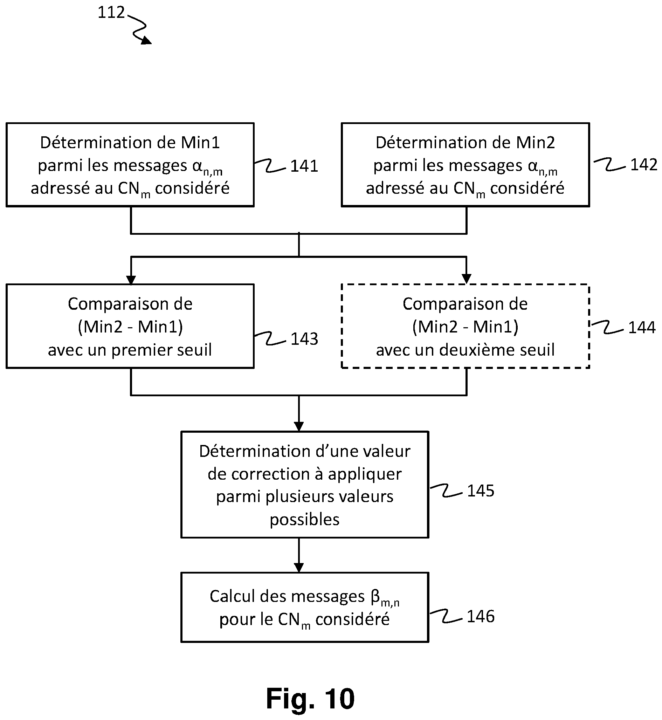

C'est pourquoi une nouvelle méthode est proposée. Cette nouvelle méthode est nommée ci-après « Adapted Offset Min-Sum » ou AOMS (adaptation de la méthode « Offset Min-Sum »). La figure 10 décrit un exemple de mise en oeuvre du calcul 112 d'un message de contrôle de parité $\beta_{m,n}$ avec la méthode AOMS. Le message de contrôle de parité $\beta_{m,n}$ est calculé pour un noeud de contrôle de parité $CN_m$ et pour un noeud de variable $VN_n$ auquel ledit noeud de contrôle de parité $CN_m$ est connecté. Le calcul 112 comprend :

- une détermination 141 d'une première plus petite valeur Mini parmi les valeurs absolues des messages de variable $\alpha_{n',m}$ associées au noeud de contrôle de parité $CN_m$,
- une détermination 142 d'une deuxième plus petite valeur Min2 parmi les valeurs absolues des messages de variable $\alpha_{n',m}$ associées au noeud de contrôle de parité $CN_m$,
- au moins une première comparaison 143 de la différence entre la deuxième plus petite valeur Min2 et la première plus petite valeur Mini avec un premier seuil,
- une détermination 145 d'une valeur de correction parmi plusieurs valeurs possibles en fonction d'un résultat de la première comparaison,
- un calcul 146 du message de contrôle de parité $\beta_{m,n}$ en fonction de la première plus petite valeur Mini et de la valeur de correction.

Dans l'exemple illustré à la figure 10, le calcul 112 comporte en outre une deuxième comparaison 144 (optionnelle) de la différence entre la deuxième plus petite valeur Min2 et la première plus petite valeur Mini avec un deuxième seuil.

Le nombre de valeurs de correction possibles dépend du nombre de seuils (et donc du nombre de comparaisons) utilisés. Par exemple, avec une seule comparaison par rapport à un seuil, la valeur de correction est choisie entre deux valeurs possibles ; avec deux comparaisons par rapport à deux seuils distincts, la valeur de correction est choisie entre trois valeurs possibles ; etc.

Dans des modes particuliers de mise en oeuvre, la première plus petite valeur Mini et la deuxième plus petite valeur Min2 sont déterminées parmi toutes les valeurs absolues des messages de variable $\alpha_{n',m}$ associées au noeud de contrôle de parité $CN_m$. L'indice n' appartient alors à l'ensemble N(m) des indices i des noeuds de variables $VN_i$ connectés au noeud de contrôle de parité $CN_m$.

Dans des modes particuliers de mise en oeuvre, la première plus petite valeur Min1 et la deuxième plus petite valeur Min2 sont déterminées parmi les valeurs absolues des messages de variable $\alpha_{n',m}$ associées au noeud de contrôle de parité $CN_m$ en excluant le message de variable $\alpha_{n,m}$ associé au noeud de variable $VN_n$. Autrement dit, Min1 et Min2 sont les deux plus petites valeurs parmi les valeurs absolues des messages de variable $\alpha_{n',m}$ associées au noeud de contrôle de parité $CN_m$ avec l'indice n' appartenant à (N(m) - n). L'ensemble (N(m) - n) est l'ensemble N(m) privé de l'indice n. De telles dispositions permettent d'obtenir de meilleures performances en contrepartie d'une implémentation un peu plus complexe.

La valeur absolue du message de contrôle de parité $\beta_{m,n}$ est par exemple calculée en soustrayant la valeur de correction choisie à la première plus petite valeur Min1. Si la valeur obtenue est négative, la valeur du message de contrôle de parité $\beta_{m,n}$ est mise à zéro.

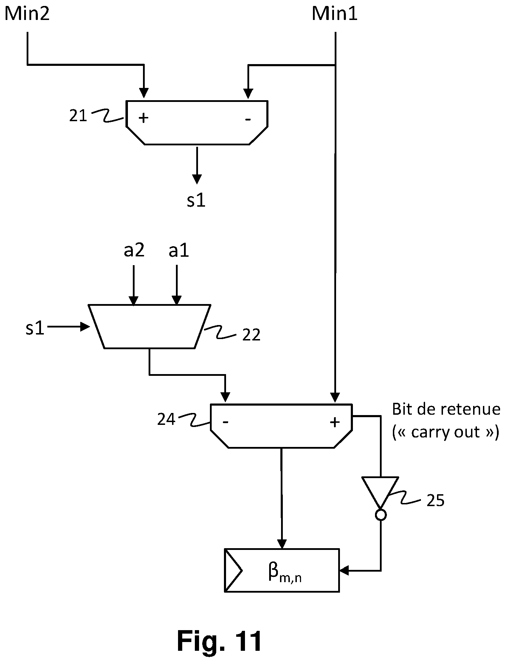

La figure 11 décrit schématiquement un exemple d'implémentation du calcul 112 d'un message de contrôle de parité $\beta_{m,n}$ avec la méthode AOMS. Dans l'exemple considéré et illustré à la figure 11, un soustracteur 21 fournit la différence s1 calculée entre les valeurs Min2 et Min1. Un multiplexeur 22 fournit une valeur de correction choisie parmi deux valeurs possibles a1 et a2 en fonction d'une comparaison entre s1 et un seuil. Un soustracteur 24 fournit la différence entre Mini et la valeur de correction choisie. Le résultat obtenu est alors mémorisé et il correspond à la valeur absolue du message de contrôle de parité $\beta_{m,n}$. Soustraire la valeur de correction revient à additionner le complément à deux de la valeur de correction. Le soustracteur 24 est configuré pour détecter un débordement (« underflow ») lors de la soustraction. Un débordement a lieu lorsque Mini est inférieur à la valeur de correction. Si un débordement a lieu, une valeur de retenue (« carry out ») prend la valeur '0', sinon la valeur de retenue prend la valeur '1'. Si un débordement a lieu, alors la valeur de $\beta_{m,n}$ est mise à zéro. La réinitialisation de la valeur de $\beta_{m,n}$ à zéro est commandée par une négation, via la porte logique « NON » 25, de la valeur de retenue.

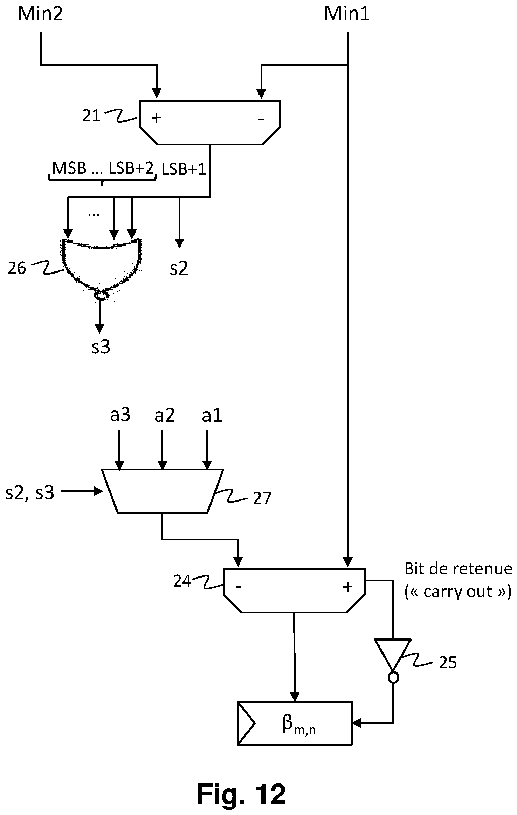

La figure 12 décrit schématiquement un deuxième exemple d'implémentation du calcul 112 d'un message de contrôle de parité $\beta_{m,n}$ avec la méthode AOMS. Dans l'exemple considéré et illustré à la figure 12, il y a deux comparaisons avec deux seuils distincts, et la valeur de correction à appliquer est choisie parmi trois valeurs possibles a1, a2 et a3.

Pour simplifier l'implémentation, il est avantageux que pour l'une au moins des comparaisons le seuil associé soit défini de telle sorte que la représentation décimale de sa valeur S puisse s'écrire sous la forme :

[Math.1]

$$S = 1 + \sum_{n=1}^{N_{LSB}-1} 2^n$$

où $N_{LSB}$ est en entier positif (le seuil est alors défini par une valeur en base binaire dont seuls les $N_{LSB}$ bits de poids faible sont égaux à '1'). En effet, dans ce cas la comparaison peut être réalisée par une porte « OU » ou par une porte « NON-OU » prenant en entrée les bits de poids forts au-delà des $N_{LSB}$ bits de poids faible de la valeur de la différence entre Min2 et Mini.

Dans l'exemple considéré et illustré à la figure 12, le premier seuil est égal à un ($N_{LSB} = 1$). Le signal s2 correspond au deuxième bit de poids le plus faible de la différence calculée entre Min2 et Mini. Le deuxième seuil est égal à trois ($N_{LSB} = 2$). Le signal s3 correspond à la sortie d'une porte « NON-OU » 26 prenant en entrée les bits de poids forts au-delà des deux bits de poids faible de la valeur de la différence entre Min2 et Mini. Cela signifie que s3 vaut '1' si lesdits bits de poids forts sont tous nuls (et dans ce cas la différence entre Min2 et Mini est inférieure ou égale au deuxième seuil). s3 vaut '0' si l'un au moins des bits de poids forts est non nul (ce qui signifie que la différence entre Min2 et Mini est strictement supérieure au deuxième seuil).

Si s2 vaut '0' et s3 vaut '1', alors la différence entre Min2 et Mini est inférieure ou égale au premier seuil. Si s2 et s3 valent '1', alors la différence entre Min2 et Mini est strictement supérieure au premier seuil et inférieure ou égale au deuxième seuil. Si s3 vaut '0', alors la différence entre Min2 et Mini est strictement supérieure au deuxième seuil.

Une porte « OU » pourrait être utilisée à la place de la porte « NON OU » 26 en inversant la logique (dans ce cas s3 vaut '1' si l'un au moins des bits de poids forts est non nul, et s3 vaut '0' si les bits de poids forts sont tous nuls).

Le multiplexeur 27 est configuré pour déterminer une valeur de correction choisie parmi trois valeurs possibles a1, a2 et a3 en fonction des résultats s2, s3 des comparaisons. Par exemple, la valeur de correction a1 est choisie si la différence entre Min2 et Mini est inférieure ou égale au premier seuil, la valeur de correction a2 est choisie si la différence entre Min2 et Mini est strictement supérieure au premier seuil et inférieure ou égale au deuxième seuil, et sinon la valeur de correction a3 est choisie.

Lorsque le décodeur supporte différents taux de codage, les différentes valeurs possibles pour la valeur de correction et/ou les différentes valeurs de seuil peuvent être prédéterminées en fonction du taux de codage utilisé. Par exemple pour un taux de codage inférieur ou égal à 1/2 on utilise a1 = 3, a2 = 2 et a3 = 0. Pour un taux de codage supérieur à 1/2, on utilise a1 = a2 = 1 et a3 = 0.

Pour les taux de codage faibles, le fait d'utiliser deux seuils et trois valeurs de correction (au lieu d'un seuil et deux valeurs de correction) permet d'améliorer significativement les performances de décodage.

Les choix des valeurs de correction peuvent également dépendre de la stratégie de quantification des valeurs d'estimation a priori (LLRs).

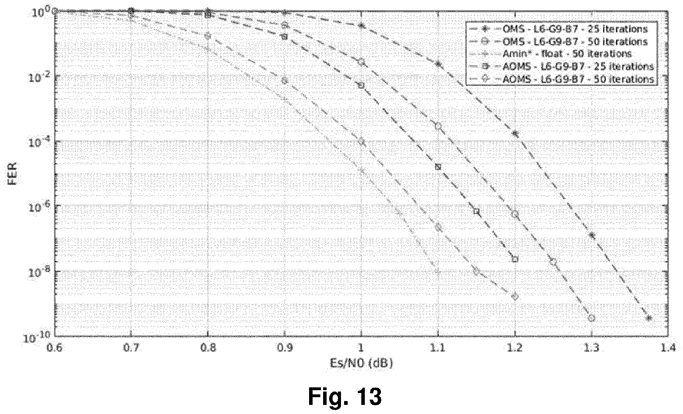

Le graphique illustré à la figure 13 présente différentes courbes de taux d'erreurs de trame obtenus avec un décodeur utilisant un taux de codage égal à 1/2, avec différentes méthodes de calcul des messages $\beta_{m,n}$. Le taux d'erreur de trame (FER) est représenté en ordonnées, le rapport signal sur bruit est représenté en abscisses (Es/$N_0$). Les différentes méthodes considérées sont Amin* (une méthode de l'art antérieur assez proche de la méthode BP-SPA), OMS (méthode « Offset Min-Sum » présentant une unique valeur de correction), et AOMS. Dans l'exemple considéré, pour les méthodes OMS et AOMS, une représentation en virgule fixe est utilisée, les LLRs sont quantifiés sur six bits (« L6 »), les variables d'estimation a posteriori $\gamma_n$ sont quantifiées sur neuf bits (« G9 ») et les messages $\beta_{m,n}$ sont quantifiés sur sept bits (« B7 »). Pour la méthode Amin*, une représentation en virgule flottante est utilisée (« float » ou « floating point » en anglais). Les résultats sont fournis pour un nombre maximal d'itérations fixé à vingt-cinq ou à cinquante.

On peut constater sur ce graphique que les performances obtenues avec la méthode AOMS sont relativement proches de celles obtenues avec la méthode Amin*. Pour un taux d'erreurs de trame de l'ordre de 10$^{-6}$, la méthode

Amin* présente un gain inférieur à 0,05 dB en termes de SNR par rapport à la méthode AOMS ; la méthode AOMS présente quant à elle un gain supérieur à 0,1 dB en termes de SNR par rapport à la méthode OMS.

La méthode AOMS pour le calcul des messages de contrôle de parité $\beta_{m,n}$ peut être utilisée en combinaison avec le critère d'arrêt spécifique dont un exemple de mise en oeuvre est décrit en référence à la figure 6. La méthode AOMS et le critère d'arrêt spécifique peuvent notamment être mis en oeuvre dans le procédé 100 de décodage LDPC décrit à la figure 4.

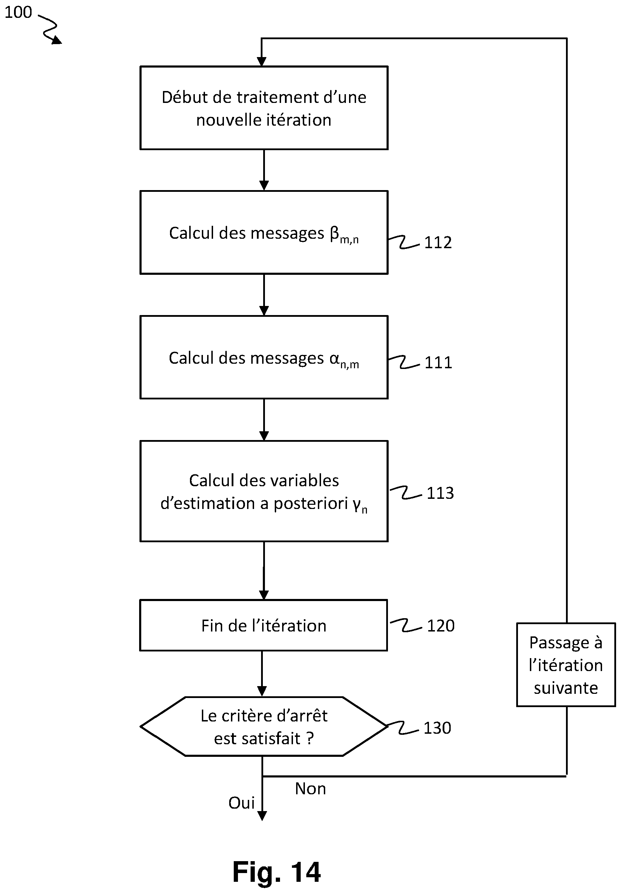

Il convient toutefois de noter que la méthode AOMS peut également être mise en oeuvre indépendamment du critère d'arrêt. Aussi, il n'est pas nécessaire que le processus de décodage LDPC dans lequel la méthode AOMS est utilisée soit basé sur un ordonnancement par couches. Il est par exemple possible d'utiliser la méthode AOMS pour le calcul 112 des messages de contrôle de parité $\beta_{m,n}$ dans un processus de décodage LDPC par inondation. A titre d'exemple, la figure 14 décrit un exemple de mise en oeuvre d'un procédé 100 de décodage LDPC avec un ordonnancement par inondation. On peut noter qu'avec un ordonnancement par inondation, l'ordre du calcul 112 des messages de contrôle de parité $\beta_{m,n}$ et du calcul 111 des messages de variable $\alpha_{n,m}$ est inversé par rapport à un ordonnancement par couches. Dans un ordonnancement par inondation, le processus de décodage alterne de manière séquentielle le calcul de tous les noeuds de contrôle de parité $CN_m$ et de tous les noeuds de variable $VN_n$. Outre les mémoires déjà décrites en référence à la figure 5, le décodeur 10 doit alors également prévoir une mémoire volatile pour mémoriser les valeurs courantes des messages de variables $\alpha_{n,m}$.

Mise à l'échelle des données :

Lorsque les données utilisées dans le processus de décodage sont quantifiées avec une représentation en virgule fixe et lorsque des taux de codage relativement faibles sont utilisés, la saturation des données (saturation des valeurs $\beta_{m,n}$ et/ou $\gamma_n$ lorsqu'elles atteignent une valeur maximale prédéterminée) peut conduire à des planchers de taux d'erreurs (« planchers de quantification »). Le format de quantification des données doit donc être choisi avec soin dans le but d'abaisser le plancher de quantification tout en limitant la complexité d'implémentation matérielle et en préservant les performances de décodage.

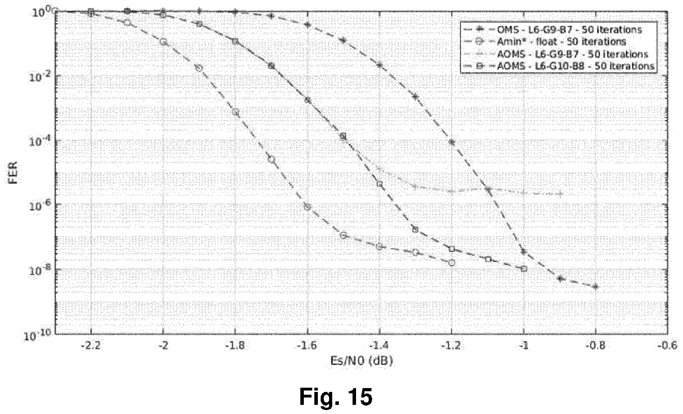

Le graphique illustré à la figure 15 présente différentes courbes de taux d'erreurs de trame obtenus avec un décodeur utilisant un taux de codage égal à 3/10, avec différentes méthodes de calcul des messages $\beta_{m,n}$. Les résultats sont fournis pour un nombre maximal d'itérations fixé à cinquante itérations. Les différentes courbes permettent de comparer les résultats obtenus pour la méthode Amin* (en virgule flottante), pour la méthode OMS avec une quantification L6-G9-B7, et pour la méthode AOMS avec d'une part une quantification L6-G9-B7 et d'autre part une quantification L6-G10-B8.

On peut observer des planchers de quantification plus ou moins sévères en fonction de la méthode et du taux de quantification utilisés. En particulier, avec la quantification L6-G9-B7, la méthode AOMS présente un plancher de taux d'erreurs relativement élevé par rapport à la méthode OMS pour les taux de codage faibles.

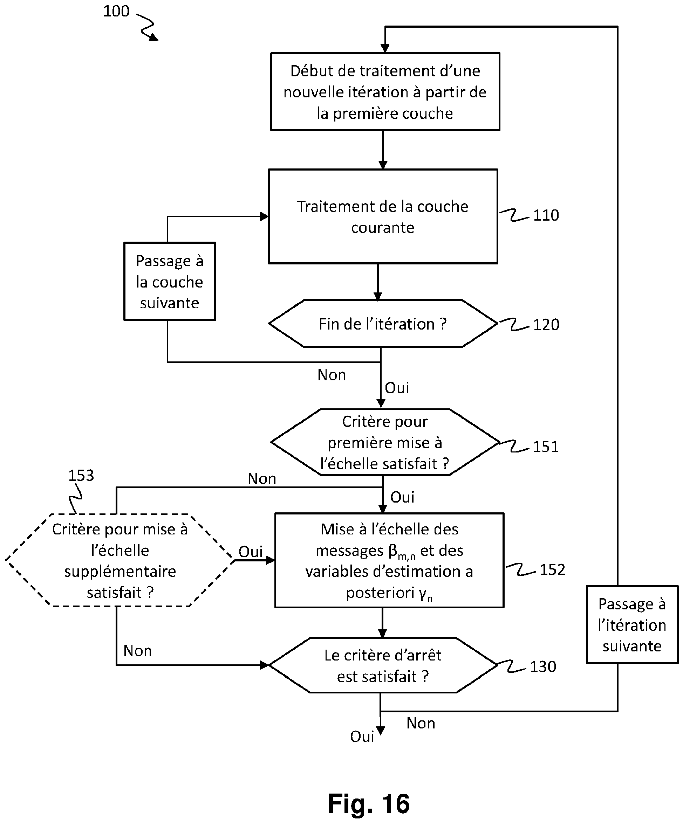

C'est pourquoi une méthode de « quantification à la volée » est proposée ci-après. La figure 16 représente schématiquement un exemple de mise en oeuvre d'un procédé 100 de décodage LDPC similaire à celui décrit en référence à la figure 4, dans lequel a été ajoutée au moins une mise à l'échelle (« scaling » en anglais) des données.

Tel qu'illustré sur la figure 16, à la fin d'une itération, le procédé 100 comporte une évaluation 151 d'un critère pour une première mise à l'échelle des données.

L'évaluation 151 du critère peut par exemple être effectuée en vérifiant si une ou plusieurs des conditions suivantes est satisfaite :

- le nombre de saturations des messages de contrôle de parité $\beta_{m,n}$ est supérieur ou égal au premier seuil de saturation,
- le nombre de saturations des variables d'estimation a posteriori $\gamma_n$ est supérieur ou égal à un deuxième seuil de saturation,
- la somme du nombre de saturations des messages de contrôle de parité $\beta_{m,n}$ et du nombre de saturations des variables d'estimation a posteriori $\gamma_n$ est supérieure ou égale à un troisième seuil de saturation.

Les différents seuils de saturation peuvent avoir des valeurs identiques ou différentes.

Lorsque le critère est satisfait, les messages de contrôle de parité $\beta_{m,n}$ et des variables d'estimation a posteriori $\gamma_n$ sont « mis à l'échelle ». Il est à noter que la mise à l'échelle peut être effectuée avant le début de l'itération suivante (dans ce cas elle est effectuée directement au cours de l'étape 152 représentée sur la figure 16), ou bien au cours de l'itération suivante (dans ce cas l'étape 152 correspond uniquement à la mise à jour d'une indication signifiant que les messages de contrôle de parité $\beta_{m,n}$ et les variables d'estimation a posteriori $\gamma_n$ doivent être mis à jour au cours de l'itération suivante avant leur première utilisation).

Une mise à l'échelle 152 correspond à attribuer à une valeur l'entier de même signe dont la valeur absolue est l'entier le plus proche supérieur à la valeur absolue de la valeur divisée par deux. De telles dispositions permettent de garantir une convergence plus faible du changement de signe d'un message de contrôle de parité $\beta_{m,n}$ ou d'une variable d'estimation a posteriori $\gamma_n$. Notamment, dans les cas particuliers 1 et -1, l'arrondi donne respectivement 1 et -1 et préserve donc le changement de signe de la métrique considérée. C'est particulièrement important pour la performance de décodage des codes irréguliers (PBRL, IRA, ARA, etc.) avec des noeuds faiblement connectés et/ou poinçonnés.

De façon optionnelle, lorsque la méthode AOMS ou une autre méthode de type OMS ou NMS est utilisée, les valeurs de correction ou de normalisation peuvent également être mis à l'échelle.

Dans ce but, l'unité de traitement 16 du décodeur 10 implémente un compteur de saturations et un module de mise à l'échelle. De nombreux décodeurs LDPC conventionnels implémentent déjà des modules de saturation. Aussi, le coût lié à l'implémentation d'un compteur du nombre de saturations est relativement faible. Le coût lié à l'implémentation d'un module de mise à l'échelle est plus important mais il reste largement acceptable.

Il est à noter qu'une variable d'estimation a posteriori $\gamma_n$ peut être utilisée plusieurs fois au cours d'une même itération. La mise à l'échelle de cette variable $\gamma_n$ ne doit toutefois être effectuée qu'une seule fois lorsqu'une mise à l'échelle est nécessaire (à la première lecture de la variable $\gamma_n$ au cours de l'itération considérée). Pour cela on peut par exemple, pour chaque variable $\gamma_n$, mémoriser un bit d'information indiquant s'il s'agit de la première lecture de ladite variable $\gamma_n$ pour l'itération en cours.

Lorsque le décodeur supporte différents taux de codage, le seuil de saturation peut avantageusement être prédéterminé en fonction du taux de codage utilisé.

Tel qu'illustré sur la figure 16, et de façon optionnelle, le procédé 100 peut aussi comporter une évaluation 153 d'un critère pour au moins une mise à l'échelle 152 supplémentaire. Le critère est par exemple satisfait après un nombre prédéterminé d'itérations successives après que la première mise à l'échelle a eu lieu. D'autres mises à l'échelle supplémentaires peuvent ensuite éventuellement être opérées après un nombre prédéterminé d'itérations successives après la dernière mise à l'échelle.

Lorsque le décodeur supporte différents taux de codage, le nombre prédéterminé d'itérations successives après lesquelles il convient de faire une mise à l'échelle supplémentaire peut avantageusement être prédéterminé en fonction du taux de codage utilisé.

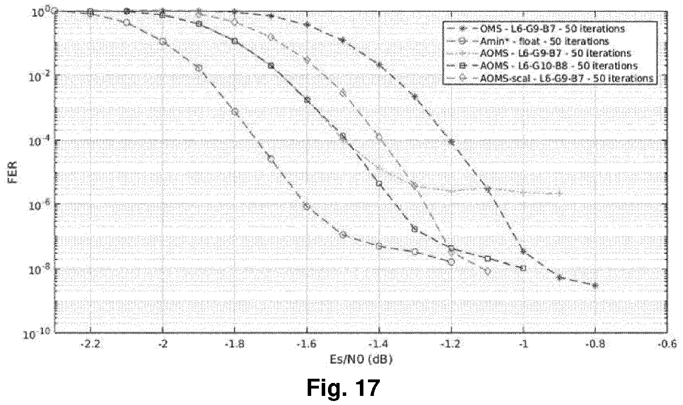

Le graphique illustré à la figure 17 est similaire à celui décrit en référence à la figure 15 avec une courbe supplémentaire (« AOMS-scal ») correspondant à la méthode AOMS avec une quantification L6-G9-B7 et avec une mise à l'échelle des messages de contrôle de parité $\beta_{m,n}$ et des variables d'estimation a posteriori $\gamma_n$. Pour obtenir cette courbe, le seuil de saturation a été fixé à 2500 messages de contrôle de parité $\beta_{m,n}$ saturés (soit environ 1,6% du nombre de messages de contrôle de parité $\beta_{m,n}$ calculés par itération), et le nombre d'itérations successives après lesquelles une mise à l'échelle supplémentaire doit être effectuée a été fixé à quatre. Il apparaît sur ce graphique que le plancher de taux d'erreurs pour la méthode AOMS avec une quantification L6-G9-B7 est significativement abaissé par la méthode de mise à l'échelle des données. On peut toutefois noter une légère baisse de performance en termes de SNR au niveau de la cascade de la courbe (« waterfall » en anglais). La méthode de mise à l'échelle des données permet d'obtenir avec une quantification L6-G9-B7 des performances en termes de plancher de taux d'erreurs comparables à celle d'une quantification L6-G10-B8. Cela permet un gain significatif sur l'empreinte mémoire du décodeur au prix d'un surcoût d'implémentation relativement faible.

La mise à l'échelle des données peut être utilisée en combinaison avec la méthode AOMS et avec le critère d'arrêt spécifique présentés précédemment. La mise à l'échelle des données, la méthode AOMS et le critère d'arrêt spécifique peuvent notamment être mis en oeuvre en combinaison dans le procédé 100 de décodage LDPC décrit à la figure 16.

Lorsque la mise à l'échelle des données est utilisée en combinaison avec le critère d'arrêt, l'évaluation du critère de saturation à l'étape 151 ou à l'étape 153 peut être effectuée avant (comme c'est illustré sur la figure 16) ou après l'étape 130 d'évaluation du critère d'arrêt.

Il convient toutefois de noter que la méthode de mise à l'échelle peut également être mis en oeuvre indépendamment de la méthode AOMS et/ou indépendamment du critère d'arrêt.

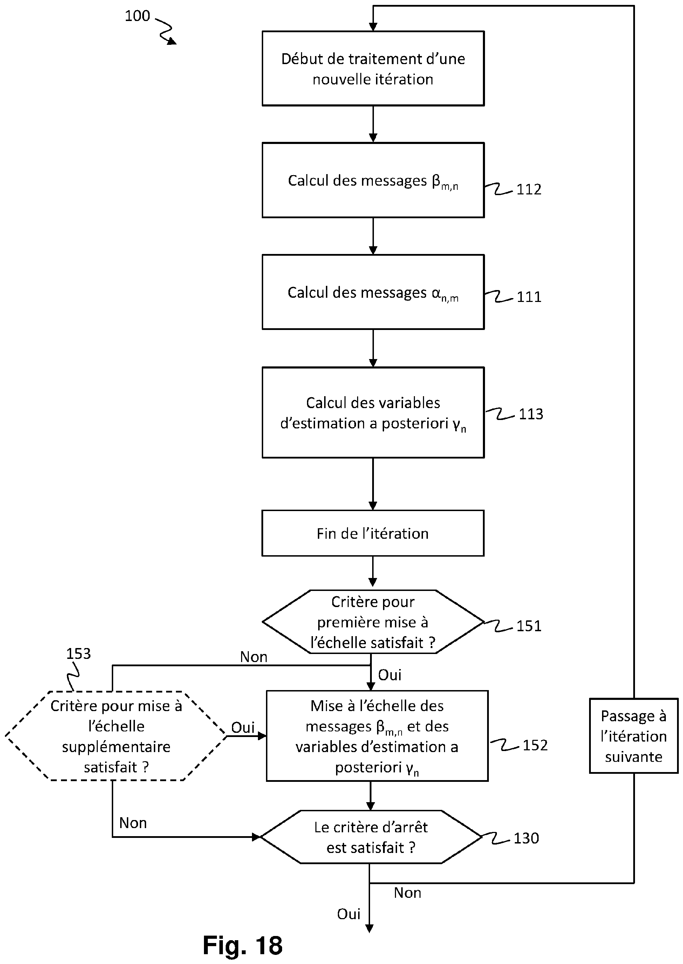

Aussi, il n'est pas nécessaire que le processus de décodage LDPC dans lequel la méthode de mise à l'échelle est utilisée soit basé sur un ordonnancement par couches. Il est par exemple possible d'utiliser la méthode de mise à l'échelle des données dans un processus de décodage LDPC par inondation. A titre d'exemple, la figure 18 décrit un exemple de mise en oeuvre d'un procédé 100 de décodage LDPC avec un ordonnancement par inondation et avec une mise à l'échelle des données.

La description ci-avant illustre clairement que, par ses différentes caractéristiques et leurs avantages, la présente invention atteint les objectifs fixés. En particulier, les différentes solutions proposées (le critère d'arrêt spécifique, la méthode de calcul « Adapted Min-Sum », et la méthode de mise à l'échelle des données) permettent d'obtenir de nouveaux compromis en termes de taux d'erreurs, de complexité d'implémentation, de débit des données, et de consommation énergétique.

Le critère d'arrêt permet avantageusement d'améliorer la robustesse du décodage à des taux de codage faibles. Il permet également de réduire le nombre d'itérations nécessaires pour décoder un mot de code, ce qui permet d'augmenter le débit moyen du décodage et de réduire la latence et la consommation énergétique du décodeur. La méthode AOMS permet d'améliorer les performances de décodage d'un mot de code par rapport à une méthode conventionnelle de type OMS. La méthode de mise à l'échelle des données permet quant à elle d'abaisser le plancher d'erreurs à des taux d'erreurs de trame particulièrement bas. La complexité introduite par ces différentes méthodes dans le processus de décodage reste largement acceptable au regard des améliorations qu'elles apportent.

Chacune des différentes méthodes peut être utilisée seule ou en combinaison avec les autres. Le critère d'arrêt est spécifique à un ordonnancement par couches, mais la méthode AOMS et la méthode de mise à l'échelle des données peuvent s'appliquer aussi bien à un ordonnancement par couches qu'à un ordonnancement par inondation.

L'invention a été décrite dans le cadre d'un décodeur LDPC pour des communications spatiales, et plus particulièrement pour des communications optiques à haut-débit. Rien n'empêcherait toutefois d'appliquer tout ou partie des méthodes proposées par l'invention à des décodeurs LDPC visant d'autres applications.

**Revendications**

1. Procédé (100) pour décoder un mot de code avec un décodeur (10) de code de contrôle de parité de faible densité, dit code LDPC, ledit code LDPC étant défini par une matrice de parité (H) binaire de taille M x N, M et N étant des entiers positifs, la matrice de parité (H) correspondant à une représentation d'un graphe bipartite (G) comprenant des connexions entre M noeuds de contrôle de parité $CN_m$ et N noeuds de variable $VN_n$, chaque ligne de la matrice de parité (H) correspondant à une équation de parité associée à un noeud de contrôle de parité $CN_m$, chaque colonne de la matrice de parité (H) correspondant à une variable associée à un noeud de variable $VN_n$, chaque élément non nul de la matrice de parité (H) correspondant à une connexion entre un noeud de contrôle de parité $CN_m$ et un noeud de variable $VN_n$, le mot de code à décoder correspondant à un ensemble de valeurs prises respectivement par lesdites variables, le procédé (100) comprenant l'exécution d'une ou plusieurs itérations jusqu'à ce qu'un critère d'arrêt soit satisfait, chaque itération comprenant :

   - un calcul (111) de messages de variable $\alpha_{n,m}$, pour les différents noeuds de variable $VN_n$, à partir de messages de contrôle de parité $\beta_{m,n}$
   - un calcul (112) de messages de contrôle de parité $\beta_{m,n}$, pour les différents noeuds de contrôle de parité $CN_m$, à partir des messages de variable $\alpha_{n,m}$,
   - lorsque la valeur calculée d'un message de contrôle de parité $\beta_{m,n}$ ou d'une variable d'estimation a posteriori dépasse une valeur de saturation prédéterminée, une saturation de ladite valeur calculée à ladite valeur de saturation,
   - un calcul (113) de variables d'estimation a posteriori à partir des messages de contrôle de parité $\beta_{m,n}$,

   **caractérisé en ce que,** à la fin d'une itération, lorsqu'un critère de saturation est vérifié, le procédé (100) comprend au moins une première mise à l'échelle (152) des messages de contrôle de parité $\beta_{m,n}$ et des variables d'estimation a posteriori, une mise à l'échelle correspondant à attribuer à une valeur l'entier de même signe dont la valeur absolue est l'entier le plus proche supérieur à la valeur absolue de la valeur divisée par deux, le critère de saturation étant vérifié lorsqu'une ou plusieurs des conditions suivantes est satisfaite :

   - un nombre de saturations des messages de contrôle de parité $\beta_{m,n}$ est supérieur ou égal à un premier seuil de saturation,
   - un nombre de saturations des variables d'estimation a posteriori est supérieur ou égal à un deuxième seuil de saturation,
   - une somme du nombre de saturations des messages de contrôle de parité $\beta_{m,n}$ et du nombre de saturations des variables d'estimation a posteriori est supérieure ou égale à un troisième seuil de saturation.

2. Procédé (100) selon la revendication 1 comportant en outre, suite à la première mise à l'échelle des messages de contrôle de parité $\beta_{m,n}$ et des variables d'estimation a posteriori, au moins une deuxième mise à l'échelle (152) des messages de contrôle de parité $\beta_{m,n}$ et des variables d'estimation a posteriori après un nombre prédéterminé d'itérations successives.

3. Procédé (100) selon la revendication 2 dans lequel le décodeur (10) supporte différents taux de codage et le nombre prédéterminé d'itérations successives est prédéterminé en fonction du taux de codage utilisé.

4. Procédé (100) selon l'une quelconque des revendications 1 à 3 dans lequel le décodeur (10) supporte différents taux de codage, le critère de saturation est vérifié lorsque le nombre de saturations des messages de contrôle de

parité $\beta_{m,n}$ est supérieur ou égal au premier seuil de saturation, et le premier seuil de saturation est prédéterminé en fonction du taux de codage utilisé.

5. Procédé (100) selon l'une quelconque des revendications 1 à 4 dans lequel la matrice de parité (H) présente une structure en couches horizontales, chaque couche correspondant à une ou plusieurs lignes consécutives de la matrice de parité (H), chaque couche présentant un seul élément non nul pour une variable donnée.

6. Procédé (100) selon l'une quelconque des revendications 1 à 5 dans lequel le code LDPC est un code quasi-cyclique, la matrice de parité (H) étant obtenue en étendant une matrice de base (B) de taille R x C par un facteur d'expansion Z, Z étant un entier positif, chaque élément de la matrice de base (B) étant remplacé par une matrice de taille Z x Z correspondant soit à une matrice nulle, soit à un décalage d'une matrice identité, la matrice de parité (H) comportant R x Z lignes et C x Z colonnes.

7. Procédé (100) selon la revendication 6 en combinaison avec la revendication 5 dans lequel chaque couche correspond aux Z lignes de la matrice de parité (H) correspondant à une ligne de la matrice de base (B).

8. Procédé (100) selon l'une quelconque des revendications 1 à 7 dans lequel le code LDPC est un code irrégulier de type à « accumulation répétition accumulation », dit code LDPC ARA, ou de type à « répétition irrégulière accumulation », dit code LDPC IRA, ou de type Raptor basé sur un protographe, dit code LDPC PBRL.

9. Procédé (100) selon l'une quelconque des revendications 1 à 8 dans lequel N est supérieur ou égal à 1000.

10. Procédé (100) selon l'une quelconque des revendications 1 à 9 dans lequel le décodeur (10) est configuré pour décoder un mot code avec un débit supérieur ou égal à 100 Mbit/s.

11. Décodeur (10) de code de contrôle de parité de faible densité, dit code LDPC, ledit code LDPC étant défini par une matrice de parité (H) binaire de taille M x N, M et N étant des entiers positifs, la matrice de parité (H) correspondant à une représentation d'un graphe bipartite (G) comprenant des connexions entre M noeuds de contrôle de parité $CN_m$ et N noeuds de variable $VN_n$, chaque ligne de la matrice de parité (H) correspondant à une équation de parité associée à un noeud de contrôle de parité $CN_m$, chaque colonne de la matrice de parité (H) correspondant à une variable associée à un noeud de variable $VN_n$, chaque élément non nul de la matrice de parité (H) correspondant à une connexion entre un noeud de contrôle de parité $CN_m$ et un noeud de variable $VN_n$, un mot de code à décoder correspondant à un ensemble de valeurs prises respectivement par lesdites variables, le décodeur (10) comportant une unité de traitement (16) configurée pour exécuter une ou plusieurs itérations jusqu'à ce qu'un critère d'arrêt soit satisfait et, à chaque itération, pour :

   - calculer des messages de variable $\alpha_{n,m}$, pour les différents noeuds de variables, à partir de messages de contrôle de parité $\beta_{m,n}$,
   - calculer des messages de contrôle de parité $\beta_{m,n}$, pour les différents noeuds de contrôle de parité, à partir des messages de variable $\alpha_{n,m}$,
   - lorsque la valeur calculée d'un message de contrôle de parité $\beta_{m,n}$ ou d'une variable d'estimation a posteriori dépasse une valeur de saturation prédéterminée, ladite valeur calculée est saturée à ladite valeur de saturation,
   - calculer des variables d'estimation a posteriori à partir des messages de contrôle de parité $\beta_{m,n}$,

   **caractérisé en ce que** à la fin d'une itération, lorsqu'un critère de saturation est vérifié, l'unité de traitement (16) est configurée pour effectuer une première mise à l'échelle des messages de contrôle de parité $\beta_{m,n}$ et des variables d'estimation a posteriori, une mise à l'échelle correspondant à attribuer à une valeur l'entier de même signe dont la valeur absolue est l'entier le plus proche supérieur à la valeur absolue de la valeur divisée par deux, le critère de saturation étant vérifié lorsqu'une ou plusieurs des conditions suivantes est satisfaite :

   - un nombre de saturations des messages de contrôle de parité $\beta_{m,n}$ est supérieur ou égal à un premier seuil de saturation,
   - un nombre de saturations des variables d'estimation a posteriori est supérieur ou égal à un deuxième seuil de saturation,
   - une somme du nombre de saturations des messages de contrôle de parité $\beta_{m,n}$ et du nombre de saturations des variables d'estimation a posteriori est supérieure ou égale à un troisième seuil de saturation.

12. Décodeur (10) selon la revendication 11 dans lequel, suite à la première mise à l'échelle des messages de contrôle

de parité $\beta_{m,n}$ et des variables d'estimation a posteriori, l'unité de traitement est configurée pour effectuer au moins une deuxième mise à l'échelle des messages de contrôle de parité $\beta_{m,n}$ et des variables d'estimation a posteriori après un nombre prédéterminé d'itérations successives.

13. Décodeur (10) selon la revendication 12 dans lequel le décodeur (10) supporte différents taux de codage et le nombre prédéterminé d'itérations successives est prédéterminé en fonction du taux de codage utilisé.

14. Décodeur (10) selon l'une quelconque des revendications 11 à 13 dans lequel le décodeur (10) supporte différents taux de codage, le critère de saturation est vérifié lorsque le nombre de saturations des messages de contrôle de parité $\beta_{m,n}$ est supérieur ou égal au premier seuil de saturation, et le premier seuil de saturation est prédéterminé en fonction du taux de codage utilisé.

15. Satellite comportant un décodeur (10) selon l'une quelconque des revendications 11 à 14.


**Patentansprüche**

1. Verfahren (100) zum Decodieren eines Codeworts mit einem Decoder (10) für Paritätsprüfcode geringer Dichte, als LDPC-Code bezeichnet, wobei der LDPC-Code durch eine binäre Paritätsmatrix (H) der Größe M x N definiert ist, wobei M und N positive ganze Zahlen sind, wobei die Paritätsmatrix (H) einer Darstellung eines bipartiten Graphen (G) entspricht, der Verbindungen zwischen M Paritätsprüfknoten $CN_m$ und N Variablenknoten $VN_n$ umfasst, wobei jede Zeile der Paritätsmatrix (H) einer Paritätsgleichung entspricht, die einem Paritätsprüfknoten $CN_m$ zugeordnet ist, wobei jede Spalte der Paritätsmatrix (H) einer Variablen entspricht, die einem Variablenknoten $VN_n$ zugeordnet ist, wobei jedes Element ungleich Null der Paritätsmatrix (H) einer Verbindung zwischen einem Paritätsprüfknoten $CN_m$ und einem Variablenknoten $VN_n$ entspricht, wobei das zu decodierende Codewort einer Menge von Werten entspricht, die jeweils von den Variablen entnommen werden, wobei das Verfahren (100) die Ausführung einer oder mehrerer Iterationen umfasst, bis ein Stoppkriterium erfüllt ist, wobei jede Iteration umfasst:

   - eine Berechnung (111) von Variablennachrichten $\alpha_{n,m}$ für die unterschiedlichen Variablenknoten $VN_n$ auf Grundlage von Paritätsprüfnachrichten $\beta_{m,n}$,
   - eine Berechnung (112) von Paritätsprüfnachrichten $\beta_{m,n}$ für die unterschiedlichen Paritätsprüfknoten $CN_m$ auf Grundlage der Variablennachrichten $\alpha_{n,m}$,
   - wenn der berechnete Wert einer Paritätsprüfnachricht $\beta_{m,n}$ oder einer a posteriori-Schätzvariablen einen vorbestimmten Sättigungswert überschreitet, eine Sättigung des berechneten Werts auf den Sättigungswert,
   - eine Berechnung (113) von a posteriori-Schätzvariablen auf Grundlage der Paritätsprüfnachrichten $\beta_{m,n}$,

   **dadurch gekennzeichnet, dass** das Verfahren (100) am Ende einer Iteration, wenn ein Sättigungskriterium verifiziert ist, mindestens eine erste Skalierung (152) der Paritätsprüfnachrichten $\beta_{m,n}$ und der a posteriori-Schätzvariablen umfasst, wobei eine Skalierung dem Zuweisen, zu einem Wert, der ganzen Zahl desselben Vorzeichens entspricht, deren Absolutwert die nächstgrößere ganze Zahl des Absolutwerts des Wertes geteilt durch zwei ist, wobei das Sättigungskriterium verifiziert ist, wenn eine oder mehrere der folgenden Bedingungen erfüllt sind:

   - eine Anzahl von Sättigungen der Paritätsprüfnachrichten $\beta_{m,n}$ ist größer oder gleich einer ersten Sättigungsschwelle,
   - eine Anzahl von Sättigungen der a posteriori-Schätzvariablen ist größer oder gleich einer zweiten Sättigungsschwelle,
   - eine Summe der Anzahl von Sättigungen der Paritätsprüfnachrichten $\beta_{m,n}$ und der Anzahl von Sättigungen der a posteriori-Schätzvariablen ist größer oder gleich einer dritten Sättigungsschwelle.

2. Verfahren (100) nach Anspruch 1, das weiter im Anschluss an die erste Skalierung der Paritätsprüfnachrichten $\beta_{m,n}$ und der a posteriori-Schätzvariablen mindestens eine zweite Skalierung (152) der Paritätsprüfnachrichten $\beta_{m,n}$ und der a posteriori-Schätzvariablen nach einer vorbestimmten Anzahl von aufeinanderfolgenden Iterationen umfasst.

3. Verfahren (100) nach Anspruch 2, wobei der Decoder (10) unterschiedliche Codierraten unterstützt und die vorbestimmte Anzahl von aufeinanderfolgenden Iterationen in Abhängigkeit von der verwendeten Codierrate vorbestimmt wird.

4. Verfahren (100) nach einem der Ansprüche 1 bis 3, wobei der Decoder (10) unterschiedliche Codierraten unterstützt, wobei das Sättigungskriterium verifiziert ist, wenn die Anzahl von Sättigungen der Paritätsprüfnachrichten $\beta_{m,n}$ größer oder gleich der ersten Sättigungsschwelle ist, und die erste Sättigungsschwelle in Abhängigkeit von der verwendeten Codierrate vorbestimmt wird.

5. Verfahren (100) nach einem der Ansprüche 1 bis 4, wobei die Paritätsmatrix (H) eine horizontale Schichtstruktur aufweist, wobei jede Schicht einer oder mehreren aufeinanderfolgenden Zeilen der Paritätsmatrix (H) entspricht, wobei jede Schicht ein einziges Element ungleich Null für eine gegebene Variable aufweist.

6. Verfahren (100) nach einem der Ansprüche 1 bis 5, wobei der LDPC-Code ein quasizyklischer Code ist, wobei die Paritätsmatrix (H) erhalten wird, indem eine Basismatrix (B) der Größe R x C um einen Expansionsfaktor Z erweitert wird, wobei Z eine positive ganze Zahl ist, wobei jedes Element der Basismatrix (B) durch eine Matrix der Größe Z x Z ersetzt wird, die entweder einer Nullmatrix oder einer Verschiebung einer Identitätsmatrix entspricht, wobei die Paritätsmatrix (H) R x Z Zeilen und C x Z Spalten umfasst.

7. Verfahren (100) nach Anspruch 6 in Kombination mit Anspruch 5, wobei jede Schicht den Z Zeilen der Paritätsmatrix (H) entspricht, die einer Zeile der Basismatrix (B) entsprechen.

8. Verfahren (100) nach einem der Ansprüche 1 bis 7, wobei der LDPC-Code ein irregulärer Code vom Typ "Akkumulation Wiederholung Akkumulation", als LDPC ARA-Code bezeichnet, oder vom Typ "irreguläre Wiederholung Akkumulation", als LDPC IRA-Code bezeichnet, oder vom Typ Raptor auf Basis eines Protographen, als LDPC PBRL-Code bezeichnet, ist.

9. Verfahren (100) nach einem der Ansprüche 1 bis 8, wobei N größer oder gleich 1000 ist.

10. Verfahren (100) nach einem der Ansprüche 1 bis 9, wobei der Decoder (10) so konfiguriert ist, dass er ein Codewort mit einer Geschwindigkeit von größer oder gleich 100 Mbit/s decodiert.

11. Decoder (10) für Paritätsprüfcode geringer Dichte, als LDPC-Code bezeichnet, wobei der LDPC-Code durch eine binäre Paritätsmatrix (H) der Größe M x N definiert ist, wobei M und N positive ganze Zahlen sind, wobei die Paritätsmatrix (H) einer Darstellung eines bipartiten Graphen (G) entspricht, der Verbindungen zwischen M Paritätsprüfknoten $CN_m$ und N Variablenknoten $VN_n$ umfasst, wobei jede Zeile der Paritätsmatrix (H) einer Paritätsgleichung entspricht, die einem Paritätsprüfknoten $CN_m$ zugeordnet ist, wobei jede Spalte der Paritätsmatrix (H) einer Variablen entspricht, die einem Variablenknoten $VN_n$ zugeordnet ist, wobei jedes Element ungleich Null der Paritätsmatrix (H) einer Verbindung zwischen einem Paritätsprüfknoten $CN_m$ und einem Variablenknoten $VN_n$ entspricht, wobei ein zu decodierendes Codewort einer Menge von Werten entspricht, die jeweils von den Variablen entnommen werden, wobei der Decoder (10) eine Verarbeitungseinheit (16) umfasst, die so konfiguriert ist, dass sie eine oder mehrere Iterationen ausführt, bis ein Stoppkriterium erfüllt ist, und bei jeder Iteration:

   - Variablennachrichten $\alpha_{n,m}$ für die unterschiedlichen Variablenknoten auf Grundlage von Paritätsprüfnachrichten $\beta_{m,n}$ berechnet,
   - Paritätsprüfnachrichten $\beta_{m,n}$ für die unterschiedlichen Paritätsprüfknoten auf Grundlage der Variablennachrichten $\alpha_{n,m}$ berechnet,
   - wenn der berechnete Wert einer Paritätsprüfnachricht $\beta_{m,n}$ oder einer a posteriori-Schätzvariablen einen vorbestimmten Sättigungswert überschreitet, der berechnete Wert auf den Sättigungswert gesättigt wird,
   - a posteriori-Schätzvariablen auf Grundlage der Paritätsprüfnachrichten $\beta_{m,n}$ berechnet,

   **dadurch gekennzeichnet, dass** am Ende einer Iteration, wenn ein Sättigungskriterium verifiziert ist, die Verarbeitungseinheit (16) so konfiguriert ist, dass sie eine erste Skalierung der Paritätsprüfnachrichten $\beta_{m,n}$ und der a posteriori-Schätzvariablen ausführt, wobei eine Skalierung dem Zuweisen, zu einem Wert, der ganzen Zahl desselben Vorzeichens entspricht, deren Absolutwert die nächstgrößere ganze Zahl des Absolutwerts des Wertes geteilt durch zwei ist, wobei das Sättigungskriterium verifiziert ist, wenn eine oder mehrere der folgenden Bedingungen erfüllt sind:

   - eine Anzahl von Sättigungen der Paritätsprüfnachrichten $\beta_{m,n}$ ist größer oder gleich einer ersten Sättigungsschwelle,
   - eine Anzahl von Sättigungen der a posteriori-Schätzvariablen ist größer oder gleich einer zweiten Sättigungsschwelle,
   - eine Summe der Anzahl von Sättigungen der Paritätsprüfnachrichten $\beta_{m,n}$ und der Anzahl von Sättigungen

18

der a posteriori-Schätzvariablen ist größer oder gleich einer dritten Sättigungsschwelle.

12. Decoder (10) nach Anspruch 11, wobei im Anschluss an die erste Skalierung der Paritätsprüfnachrichten $\beta_{m,n}$ und der a posteriori-Schätzvariablen die Verarbeitungseinheit so konfiguriert ist, dass sie mindestens eine zweite Skalierung der Paritätsprüfnachrichten $\beta_{m,n}$ und der a posteriori-Schätzvariablen nach einer vorbestimmten Anzahl von aufeinanderfolgenden Iterationen ausführt.

13. Decoder (10) nach Anspruch 12, wobei der Decoder (10) unterschiedliche Codierraten unterstützt und die vorbestimmte Anzahl von aufeinanderfolgenden Iterationen in Abhängigkeit von der verwendeten Codierrate vorbestimmt wird.

14. Decoder (10) nach einem der Ansprüche 11 bis 13, wobei der Decoder (10) unterschiedliche Codierraten unterstützt, wobei das Sättigungskriterium verifiziert ist, wenn die Anzahl von Sättigungen der Paritätsprüfnachrichten $\beta_{m,n}$ größer oder gleich der ersten Sättigungsschwelle ist, und die erste Sättigungsschwelle in Abhängigkeit von der verwendeten Codierrate vorbestimmt wird.

15. Satellit, der einen Decoder (10) nach einem der Ansprüche 11 bis 14 umfasst.

## Claims

1. A method (100) for decoding a codeword with a low-density parity check code decoder (10), so-called LDPC code, said LDPC code being defined by an M x N size binary parity matrix (H), M and N being positive integers, the parity matrix (H) corresponding to a representation of a bipartite graph (G) comprising connections between M parity check nodes $CN_m$ and N variable nodes $VN_n$,

   each line of the parity matrix (H) corresponding to a parity equation associated with a parity check node $CN_m$,
   each column of the parity matrix (H) corresponding to a variable associated with a variable node $VN_n$,
   each non-zero element of the parity matrix (H) corresponding to a connection between a parity check node $CN_m$ and a variable node $VN_n$,
   the codeword to be decoded corresponding to a set of values taken respectively by said variables, the method (100) comprising executing one or more iterations until a stop criterion is met, each iteration comprising:

   - calculating (111) variable messages $\alpha_{n,m}$, for the different variable nodes $VN_n$, from parity check messages $\beta_{m,n}$,
   - calculating (112) parity check messages $\beta_{m,n}$, for the different parity check nodes $CN_m$, from the variable messages $\alpha_{n,m}$,
   - when the calculated value of a parity check message $\beta_{m,n}$ or of an a posteriori estimation variable exceeds a predetermined saturation value, saturating said calculated value at said saturation value,
   - calculating (113) a posteriori estimation variables from the parity check messages $\beta_{m,n}$,

   **characterized in that,** at the end of an iteration, when a saturation criterion is met, the method (100) comprises at least one first scaling (152) of the parity check messages $\beta_{m,n}$ and of the a posteriori estimation variables, a scaling corresponding to assigning to a value the integer with the same sign whose absolute value is the closest integer greater than the absolute value of the value divided by two, the saturation criterion being met when one or more of the following conditions is met:

   - a number of saturations of the parity check messages $\beta_{m,n}$ is greater than or equal to a first saturation threshold,
   - a number of saturations of the a posteriori estimation variables is greater than or equal to a second saturation threshold,
   - a sum of the number of saturations of the parity check messages $\beta_{m,n}$ and of the number of saturations of the a posteriori estimation variables is greater than or equal to a third saturation threshold.

2. The method (100) according to claim 1, further including, following the first scaling of the parity check messages $\beta_{m,n}$ and of the a posteriori estimation variables, at least one second scaling (152) of the parity check messages $\beta_{m,n}$ and of the a posteriori estimation variables after a predetermined number of successive iterations.

3. The method (100) according to claim 2, in which the decoder (10) supports different coding rates and the predetermined number of successive iterations is predetermined according to the used coding rate.

4. The method (100) according to any one of claims 1 to 3, in which the decoder (10) supports different coding rates, the saturation criterion is met when the number of saturations of the parity check messages $\beta_{m,n}$ is greater than or equal to the first saturation threshold, and the first saturation threshold is predetermined according to the used coding rate.

5. The method (100) according to any one of claims 1 to 4, wherein the parity matrix (H) has a horizontal layered structure, each layer corresponding to one or more consecutive lines of the parity matrix (H), each layer having one single non-zero element for a given variable.

6. The method (100) according to any one of claims 1 to 5, wherein the LDPC code is a quasi-cyclic code, the parity matrix (H) being obtained by extending a R x C size base matrix (B) by an expansion factor Z, Z being a positive integer, each element of the base matrix (B) being replaced by a $Z \times Z$ size matrix corresponding either to a zero matrix or to a shift of an identity matrix, the parity matrix (H) including R x Z lines and C x Z columns.

7. The method (100) according to claim 6 in combination with claim 5, wherein each layer corresponds to the Z lines of the parity matrix (H) corresponding to a line of the base matrix (B).

8. The method (100) according to any one of claims 1 to 7, wherein the LDPC code is an irregular code of the "accumulate repeat accumulate" type, so-called LDPC ARA code, or of the "irregular repeat accumulate" type, so-called LPDC IRA code, or of the protograph-based Raptor-like type, so-called LPDC PBRL.

9. The method (100) according to any one of claims 1 to 8, wherein N is greater than or equal to 1,000.

10. The method (100) according to any one of claims 1 to 9, wherein the decoder (10) is configured to decode a codeword with a flow rate greater than or equal to 100 Mbit/s.

11. A low-density parity check code decoder (10), so-called LDPC code, said LDPC code being defined by an M x N size binary parity matrix (H), M and N being positive integers, the parity matrix (H) corresponding to a representation of a bipartite graph (G) comprising connections between M parity check nodes $CN_m$ and N variable nodes $VN_n$,

each line of the parity matrix (H) corresponding to a parity equation associated with a parity check node $CN_m$,
each column of the parity matrix (H) corresponding to a variable associated with a variable node $VN_n$,
each non-zero element of the parity matrix (H) corresponding to a connection between a parity check node $CN_m$ and a variable node $VN_n$,
a codeword to be decoded corresponding to a set of values taken respectively by said variables, the decoder (10) including a processing unit (16) configured to execute one or more iterations until a stop criterion is met, to:

- calculate variable messages $\alpha_{n,m}$, for the different variable nodes, from parity check messages $\beta_{m,n}$,
- calculate parity check messages $\beta_{m,n}$, for the different parity check nodes, from the variable messages $\alpha_{n,m}$,
- when the calculated value of a parity check message $\beta_{m,n}$ or of an a posteriori estimation variable exceeds a predetermined saturation value, said calculated value is saturated at said saturation value,
- calculate a posteriori estimation variables from the parity check messages $\beta_{m,n}$,

**characterized in that,** at the end of an iteration, when a saturation criterion is met, the processing unit (16) is configured to perform a first scaling of the parity check messages $\beta_{m,n}$ and of the a posteriori estimation variables, a scaling corresponding to assigning to a value the integer with the same sign whose absolute value is the closest integer greater than the absolute value of the value divided by two, the saturation criterion being met when one or more of the following conditions is met:

- a number of saturations of the parity check messages $\beta_{m,n}$ is greater than or equal to a first saturation threshold,
- a number of saturations of the a posteriori estimation variables is greater than or equal to a second saturation threshold,
- a sum of the number of saturations of the parity check messages $\beta_{m,n}$ and of the number of saturations of the a posteriori estimation variables is greater than or equal to a third saturation threshold.

**12.** The decoder (10) according to claim 11, wherein, following the first scaling of the parity check messages $\beta_{m,n}$ and of the a posteriori estimation variables, the processing unit is configured to perform at least one second scaling of the parity check messages $\beta_{m,n}$ and of the a posteriori estimation variables after a predetermined number of successive iterations.

**13.** The decoder (10) according to claim 12, wherein the decoder (10) supports different coding rates and the predetermined number of successive iterations is predetermined according to the used coding rate.

**14.** The decoder (10) according to any one of claims 1 to 13, wherein the decoder (10) supports different coding rates, the saturation criterion is met when the number of saturations of the parity check messages $\beta_{m,n}$ is greater than or equal to the first saturation threshold, and the first saturation threshold is predetermined according to the used coding rate.

**15.** A satellite including a decoder (10) according to any one of claims 11 to 14.

$$
H \quad \left\{ \begin{array}{cccccccccccc}
1 & 0 & 0 & 0 & \cdots & 0 & 0 & 1 & \cdots & 0 & 0 & 0 \\
0 & 1 & 0 & \cdots & & 1 & 0 & 0 & \cdots & & 0 & 0 \\
\vdots & \vdots & \vdots & & & \vdots & \vdots & \vdots & & & \vdots & \vdots \\
0 & 0 & 0 & \cdots & & 1 & 0 & 1 & \cdots & & 0 & 0 \\
\end{array} \right\} \quad M
$$

## Fig. 1

## Fig. 2

B

$$
\begin{Bmatrix}
0 & 92 & -1 & 0 & \cdots & & \cdots & 54 & -1 & -1 & -1 \\
-1 & -1 & 0 & 17 & \cdots & & \cdots & -1 & 0 & -1 & -1 \\
\vdots & \vdots & \vdots & \vdots & & & & \vdots & \vdots & \vdots & \vdots \\
-1 & 0 & 12 & -1 & \cdots & 28 & \cdots & -1 & 0 & -1 & -1
\end{Bmatrix}
$$

Z

Z

28

Z

Z

Z

Z

## Fig. 3

100

Début de traitement d'une
nouvelle itération à partir de
la première couche

Calcul des messages $\alpha_{n,m}$    111

Calcul des messages $\beta_{m,n}$    112

110

Calcul des variables
d'estimation a posteriori $\gamma_n$    113

Calcul du syndrome partiel    114

Passage à
la couche
suivante

Fin de l'itération ?    120

Non    Oui

Le critère d'arrêt
est satisfait ?    130

Passage à
l'itération
suivante

Oui   Non

**Fig. 4**

Fig. 5

130

Tous les syndromes
partiels sont nuls ? — 131

Oui          Non

Incrémentation du
compteur — 132

Décrémentation du
compteur, sauf si le
compteur est déjà nul — 133

Le compteur est
supérieur au seuil ? — 134

# Fig. 6

**Fig. 7**

**Fig. 8**

**Fig. 9**

112

Détermination de Min1
parmi les messages $\alpha_{n,m}$
adressé au $CN_m$ considéré      141

Détermination de Min2
parmi les messages $\alpha_{n,m}$
adressé au $CN_m$ considéré      142

Comparaison de
(Min2 - Min1)
avec un premier seuil      143

Comparaison de
(Min2 - Min1)
avec un deuxième seuil      144

Détermination d'une valeur
de correction à appliquer
parmi plusieurs valeurs
possibles      145

Calcul des messages $\beta_{m,n}$
pour le $CN_m$ considéré      146

**Fig. 10**

Min2                              Min1

21 +      −

s1

a2   a1

s1      22

24 −      +      Bit de retenue
                 (« carry out »)

25

$\beta_{m,n}$

**Fig. 11**

Min2                                    Min1

21 —  [ +            -  ]

MSB ... LSB+2, LSB+1

...

26 —                    s2

s3

a3    a2    a1

s2, s3 ——>  [        ]  —— 27

Bit de retenue
(« carry out »)

24 —  [ -            + ]

25

$\beta_{m,n}$

**Fig. 12**

**Fig. 13**

100

Début de traitement d'une
nouvelle itération

Calcul des messages $\beta_{m,n}$    112

Calcul des messages $\alpha_{n,m}$    111

Calcul des variables
d'estimation a posteriori $\gamma_n$    113

Fin de l'itération    120

Passage à
l'itération
suivante

Le critère d'arrêt
est satisfait ?    130

Non

Oui

## Fig. 14

**Fig. 15**

100

**Début de traitement d'une nouvelle itération à partir de la première couche**

**Traitement de la couche courante** — 110

**Passage à la couche suivante**

**Fin de l'itération ?** — 120

Non

Oui

**Critère pour première mise à l'échelle satisfait ?** — 151

Non

Oui

153

**Critère pour mise à l'échelle supplémentaire satisfait ?**

Oui

**Mise à l'échelle des messages $\beta_{m,n}$ et des variables d'estimation a posteriori $\gamma_n$** — 152

Non

**Le critère d'arrêt est satisfait ?** — 130

**Passage à l'itération suivante**

Non

Oui

**Fig. 16**

**Fig. 17**

Fig. 18

**RÉFÉRENCES CITÉES DANS LA DESCRIPTION**

**Documents brevets cités dans la description**

- US 2017026055 A1
- US 9059742 B1

**Littérature non-brevet citée dans la description**

- **DE A. HERA et al.** Analysis and Implementation of On-the-Fly Stopping Criteria for Layered QC LDPC Decoders. *22ème conférence internationale « Mixed design of integrated circuits and systems »,* 27 Juin 2015, 287-291
- **V. PIGNOLY.** *Etude de codes LDPC pour applications spatiales optiques et conception des décodeurs associés,* 26 Mars 2021
- **T.T NGUYEN LY.** *Efficient Hardware Implementations of LDPC Decoders through Eploiting Impreciseness in Message-Passing Decoding Algorithms*